# EUROPEAN PATENT APPLICATION

(11) **EP 2 333 499 A1**
(43) Date of publication of application: **15.06.2011**
(21) Application number: 09816153.2
(22) Date of filing: 24.09.2009
(51) Int. Cl.: G01J 1/02, H01L 27/14, H01L 35/32

(54) **INFRARED SENSOR**

(30) Priority: 25.09.2008 JP 2008246926; 31.03.2009 JP 2009087008; 31.03.2009 JP 2009087009
(71) Applicant: Panasonic Electric Works Co., Ltd., Kadoma-shi, Osaka 571-8686 (JP)
(72) Inventor: TSUJI, Koji, Kadoma-shi Osaka 571-8686 (JP); HAGIHARA, Yosuke, Kadoma-shi Osaka 571-8686 (JP); USHIYAMA, Naoki, Kadoma-shi Osaka 571-8686 (JP)
(74) Representative: Appelt, Christian W.
(86) International application number: PCT/JP2009/066509
(87) International publication number: WO 2010/035738

(57) **Abstract**

The infrared sensor (1) includes a base (10), and an infrared detection element (3) formed over a surface of the base (10). The infrared detection element (3) includes an infrared absorption member (33) in the form of a thin film configured to absorb infrared, a temperature detection member (30) configured to measure a temperature difference between the infrared absorption member (33) and the base (10), and a safeguard film (39). The infrared element (3) is spaced from the surface of the base (10) for thermal insulation. The temperature detection member (30) includes a p-type polysilicon layer (35) formed over the infrared absorption member (33) and the base (10), an n-type polysilicon layer (34) formed over the infrared absorption member (33) and the base (10) without contact with the p-type polysilicon layer (35), and a connection layer (36) configured to electrically connect the p-type polysilicon layer (35) to the n-type polysilicon layer (34). The safeguard film (39) is a polysilicon layer formed on an infrared incident surface defined as an opposite surface of the infrared absorption member (33) from the base (10) to cover the infrared incident surface.

## Description

### Technical Field

The present invention relates to an infrared sensor.

### Background Art

In the past, there has been proposed an infrared sensor which detects infrared (e.g., infrared having a wavelength of 8 to 12 µm which emitted from a human body). A document 1 (Japanese patent publication No. 2576259) and a document 2 (Japanese patent publication No. 3287173) disclose infrared sensors manufactured by use of micromachining techniques. This kind of infrared sensor includes a thin film-shaped infrared absorption member and a temperature detection member. The infrared absorption member absorbs infrared and converts the absorbed infrared into heat. The temperature detection member measures a change in temperature of the infrared absorption member.

The infrared sensor disclosed in the above document 1 includes a silicon substrate, and a silicon nitride film formed on the silicon substrate. The silicon substrate is provided with a cavity for thermal insulation. The silicon nitride film has its portion covering the cavity which acts as the infrared absorption member. In this infrared sensor, a thermopile is adopted as the temperature detection member. The thermopile is made of an n-type silicon film and a p-type silicon film formed on the silicon nitride film, by use of patterning techniques and the like.

The infrared sensor disclosed in the document 2 includes a dielectric layer (infrared absorption member) having high absorption in infrared wavelength region. On the dielectric layer is formed a temperature detection semiconductor layer. Below the dielectric layer under the temperature detection semiconductor layer is formed a cavity for suppressing conduction of heat from the temperature detection semiconductor layer to an outside. In this infrared sensor, the dielectric layer is preferred to be thinned in order to decrease a heat conductance thereof (increase a resistance thereof) and in order to increase a response speed. When the dielectric layer is thinned, the dielectric layer being the infrared absorption member is likely to suffer from a warp, and the infrared sensor may have poor structural stability and low sensitivity.

In addition, the infrared sensor disclosed in the document 2 uses a bolometer type infrared detection element. Therefore, it is necessary to flow a current in order to measure a change in a resistance of the infrared detection element. This causes increased power consumption. Moreover, since the bolometer type infrared detection element heats itself, the infrared detection element is likely to suffer from a warp caused by thermal stress resulting from the self-heating. Further, a resistance temperature coefficient of the infrared detection element is changed by a temperature variation resulting from the self-heating and/or a surrounding temperature variation. In view of this, a temperature compensation polysilicon layer is necessary to improve accuracy. However, to provide the temperature compensation polysilicon layer enlarges the infrared sensor, and increases a production cost.

Meanwhile, in the infrared sensor disclosed in the document 1, the thermopile is used as the temperature detection member. Differently from the bolometer type infrared detection element, the thermopile needs no current to measure the temperature. Thus, the thermopile does not produce self-heating. Therefore, the infrared absorption member is kept free from a warp caused by the self-heating. Further, power consumption can be reduced. In addition, since a sensitivity of the thermopile does not depend on its temperature, the thermopile has high accuracy.

In order to form the thermopile disclosed in the document 1, it is necessary to pattern, by use of etching techniques, the n-type silicon film and the p-type silicon film formed on the infrared absorption member. When the thermopile is formed, the infrared absorption member is likely to be etched together with the p-type silicon film and/or the n-type silicon film. In this situation, a thin film structure comprising the infrared sensor and the thermopile formed thereon is likely to suffer from a warp, and the infrared sensor may have poor structural stability and low sensitivity.

### Disclosure of Invention

In view of the above insufficiency, the present invention has been aimed to propose an infrared sensor which is capable of making an infrared absorption member thin, yet keeping it free from a warp.

The infrared sensor in accordance with the present invention comprises a base and an infrared detection element formed over a surface of the base. The infrared detection element comprises an infrared absorption member in the form of a thin film configured to absorb infrared, a temperature detection member configured to measure a temperature difference between the infrared absorption member and the base, and a safeguard film. The infrared absorption member is spaced from the surface of the base for thermal insulation. The temperature detection member includes a thermocouple which includes a p-type polysilicon layer formed over the infrared absorption member and the base, an n-type polysilicon layer formed over the infrared absorption member and the base without contact with the p-type polysilicon layer, and a connection layer configured to electrically connect the p-type polysilicon layer to the n-type polysilicon layer. The safeguard film is configured to serve to protect the infrared absorption member and prevent a warp of the infrared absorption member at the time of forming the p-type polysilicon layer and the n-type polysilicon layer. The safeguard film is a polysilicon layer formed on an infrared incident surface defined as an opposite surface of the infrared absorption member from the base to cover the infrared incident surface.

According to the present invention, since the temperature detection member does not heat itself, the infrared absorption member is kept free from a warp which would otherwise occur due to the self-heating of the temperature detection member. In addition, since the safeguard film is formed on the infrared incident surface of the infrared absorption member, .it is possible to prevent the infrared absorption member from being etched to be thinned at the time of forming the p-type polysilicon layer and the n-type polysilicon layer. In addition, the safeguard film can enhance uniform distribution of stress in the infrared absorption member. Therefore, it is possible to protect the infrared absorption member and prevent a warp of the infrared absorption member at the time of forming the p-type polysilicon layer and the n-type polysilicon layer. Consequently, it is possible to make the infrared absorption member thin, yet keeping the infrared absorption member free from a warp, and therefore it is possible to improve the sensitivity.

In a preferred aspect, the infrared detection element includes a support member configured to couple the infrared absorption member to the base. The support member is coupled to the base only at a single point.

With this aspect, it is possible to prevent deformation of the infrared absorption member which would otherwise occur when the base is deformed by an external stress, a thermal stress, or the like.

In a preferred embodiment, the infrared detection element includes a support member configured to couple the infrared absorption member to the base. The support member is coupled to the infrared absorption member only at two points.

With this aspect, the infrared absorption member can have a high tolerance to a torsional stress.

In a preferred embodiment, the p-type polysilicon layer, the n-type polysilicon layer, and the safeguard film have the same thickness.

With this aspect, the uniform distribution of stress in the infrared absorption member can be enhanced, and therefore the infrared absorption member can be kept free from a warp.

In a preferred aspect, the p-type polysilicon layer, the n-type polysilicon layer, and the safeguard film are formed in a common plane.

With this aspect, the uniform distribution of stress in the infrared absorption member can be enhanced, and therefore the infrared absorption member can be kept free from a warp.

In a preferred aspect, the infrared detection member includes an infrared absorption film formed over an opposite surface of the safeguard film from the base. The infrared absorption film has its thickness of λ/4n, wherein n denotes a reflective index of the infrared absorption film, and λ denotes a center wavelength of the infrared to be detected by the infrared detection element.

With this aspect, it is possible to enhance absorption efficiency of the infrared absorption film for the infrared to be detected by the infrared detection element, and therefore the sensitivity can be improved.

In a preferred aspect, the safeguard film comprises a p-type safeguard film formed integrally with the p-type polysilicon layer and having an impurity concentration of 10¹⁸ to 10²⁰ cm⁻³, and an n-type safeguard film formed integrally with the n-type polysilicon layer and having an impurity concentration of 10¹⁸ to 10²⁰ cm⁻³.

With this aspect, it is possible to reduce a resistance of the thermocouple, and therefore the S/N ratio can be improved.

In a preferred aspect, the safeguard film has an impurity concentration of 10¹⁸ to 10²⁰ cm⁻³. The safeguard film has its thickness of λ/4n, wherein n denotes a reflective index of the safeguard film, and denotes a center wavelength of the infrared to be detected by the infrared detection element.

With this aspect, it is possible to enhance absorption efficiency of the safeguard film for the infrared to be detected by the infrared detection element, and therefore the sensitivity can be improved.

In a preferred aspect, the safeguard film has an impurity concentration of 10¹⁸ to 10²⁰ cm⁻³. At least one of the p-type polysilicon layer and the n-type polysilicon layer has the impurity of the same kind and the same concentration as the safeguard film.

With this aspect, an S/N ratio of an output of the temperature detection member can be improved. Further, the safeguard film can be formed through the same process as at least one of the p-type polysilicon layer and the n-type polysilicon layer. Consequently, the production cost can be reduced.

In a preferred aspect, the infrared sensor includes plural cells each including the infrared detection element. The plural cells are arranged over the surface of the base in an array manner.

With this aspect, it is possible to provide an infrared image sensor.

In a more preferred aspect, the cell includes a MOS transistor configured to read out an output of the temperature detection member.

With this aspect, it is possible to reduce the number of the output pads, and therefore it is possible to downsize the infrared sensor and reduce the production cost thereof.

In a further preferred aspect, the MOS transistor includes a gate electrode defined by a polysilicon film having the same thickness as the safeguard film.

With this aspect, the gate electrode of the MOS transistor and the safeguard film can be formed through the same process. Accordingly, the number of the steps of the method for manufacturing the infrared sensor can be reduced, and therefore it is possible to reduce production cost thereof.

In a preferred embodiment, the base is provided with a cavity for thermally insulation between the base and the infrared absorption member. The infrared detection member includes a thin film structure which comprises a plurality of a small and thin film structures, and is disposed over the cavity. Each of the small and thin film structures includes the infrared absorption member in the form of a thin film configured to absorb infrared, and the temperature detection member formed on the infrared absorption member and configured to measure a temperature of the same infrared absorption member. Between the small and thin film structures are formed slits. All the temperature detection members are electrically connected to each other in such a relation as to provide a temperature-dependent output which is greater than any single one of the temperature detection members.

With this aspect, the infrared sensor can improve its response speed and sensitivity. Furthermore, it is possible to restrain deformation of each infrared detection member even in the presence of a stress in the base or subject to external stress or thermal stress. Thereby, it is possible to improve structural stability of the infrared sensor and to stabilize the sensitivity of the infrared sensor.

In a more preferred aspect, the thin film structure includes a connection member configured to connect the small and thin film structures together.

According to this aspect, it is possible to prevent breakage of the infrared sensor which would otherwise occur due to a stress caused by an external temperature variation or impact at the time of using the infrared sensor. It is enabled to prevent breakage of the infrared sensor at the time of manufacturing the same. The fabrication yield can be improved.

### Brief Description of Drawings

FIG. 1A is a plane view illustrating an infrared sensor of the first embodiment,
FIG. 1B is shows a cross sectional view of the infrared sensor of the first embodiment along the line D-D of FIG. 1A,
FIG. 1C is shows a cross sectional view of the infrared sensor of the first embodiment along the line E-E of FIG. 1A,
FIG. 2A is a plane view illustrating the above infrared sensor,
FIG. 2B is an equivalent circuit schematic illustrating the above infrared sensor,
FIG. 3 is a schematic plane view illustrating an infrared sensor module including the above infrared sensor,
FIG. 4 is an explanatory view illustrating the infrared sensor module including the above infrared sensor,
FIG. 5 is a process chart illustrating a method of manufacturing the above infrared sensor,
FIG. 6 is a process chart illustrating the method of manufacturing the above infrared sensor,
FIG. 7A is a plane view illustrating an infrared sensor of the second embodiment,
FIG. 7B is an enlarged view illustrating the infrared sensor of the second embodiment,
FIG. 7C is shows a cross sectional view of the infrared sensor of the second embodiment along the line D-D of FIG. 7A,
FIG. 8 is an equivalent circuit schematic illustrating the above infrared sensor,
FIG. 9 is a schematic plane view illustrating an infrared sensor module including the above infrared sensor,
FIG. 10 is an explanatory view illustrating the infrared sensor module including the above infrared sensor,
FIG. 11A is a plane view illustrating a modification of the above infrared sensor,
FIG. 11B shows a cross sectional view of the modification of the above infrared sensor along the line D-D of FIG. 11A,
FIG. 12A is a plane view illustrating another modification of the above infrared sensor,
FIG. 12B shows a cross sectional view of said another modification of the above infrared sensor along the line D-D of FIG. 12A,
FIG. 13 is a plane view illustrating an infrared sensor of the third embodiment,
FIG. 14 is a schematic plane view illustrating the above infrared sensor,
FIG. 15 is a schematic plane view illustrating the above infrared sensor,
FIG. 16A is a partial plane view illustrating the above infrared sensor,
FIG. 16B shows a cross sectional view of the above infrared sensor along the line D-D of FIG. 16A,
FIG. 17 is a partial plane view illustrating the above infrared sensor,
FIG. 18 is a partial plane view illustrating the above infrared sensor,
FIG. 19A is a partial plane view illustrating the above infrared sensor,
FIG. 19B shows a cross sectional view of the above infrared sensor along the line D-D of FIG. 19A,
FIG. 20A is a partial plane view illustrating the above infrared sensor,
FIG. 20B is a schematic cross sectional view illustrating the above infrared sensor,
FIG. 21A is a partial plane view illustrating the above infrared sensor,
FIG. 21B is a schematic cross sectional view illustrating the above infrared sensor,
FIG. 22 is a partial cross sectional view illustrating the above infrared sensor,
FIG. 23 is a partial cross sectional view illustrating the above infrared sensor,
FIG. 24A is an explanatory view illustrating the above infrared sensor,
FIG. 24B is an explanatory view illustrating the above infrared sensor,
FIG. 25 is an equivalent circuit schematic illustrating the above infrared sensor,
FIG. 26 is a schematic cross sectional view illustrating the infrared sensor module including the above infrared sensor,
FIG. 27 is a process chart illustrating a method of manufacturing the above infrared sensor,
FIG. 28 is a process chart illustrating the method of manufacturing the above infrared sensor,
FIG. 29 is a process chart illustrating the method of manufacturing the above infrared sensor,
FIG. 30 is a process chart illustrating the method of manufacturing the above infrared sensor,
FIG. 31 is a partial plane view illustrating the infrared sensor of the first modification of the above embodiment,
FIG. 32 is a partial plane view illustrating the infrared sensor of the second modification of the above embodiment,
FIG. 33 is a partial plane view illustrating the infrared sensor of the third modification of the above embodiment,
FIG. 34 is a partial enlarged view of the above infrared sensor,
FIG. 35 is a partial plane view illustrating the infrared sensor of the fourth modification of the above embodiment,
FIG. 36 is a partial plane view illustrating the infrared sensor of the fifth modification of the above embodiment,
FIG. 37 is a partial plane view illustrating the infrared sensor of the sixth modification of the above embodiment,
FIG. 38 is a plane view illustrating the infrared sensor of the fourth embodiment,
FIG. 39 is a schematic plane view illustrating the above infrared sensor,
FIG. 40 is a partial plane view illustrating the above infrared sensor,
FIG. 41 is a partial plane view illustrating the above infrared sensor,
FIG. 42 is a partial plane view illustrating the infrared sensor of the first modification of the above embodiment,
FIG. 43 is a partial plane view illustrating the infrared sensor of the second modification of the above embodiment, and
FIG. 44 is a partial enlarged view of the above infrared sensor.

### Best Mode for Carrying Out the Invention

### (FIRST EMBODIMENT)

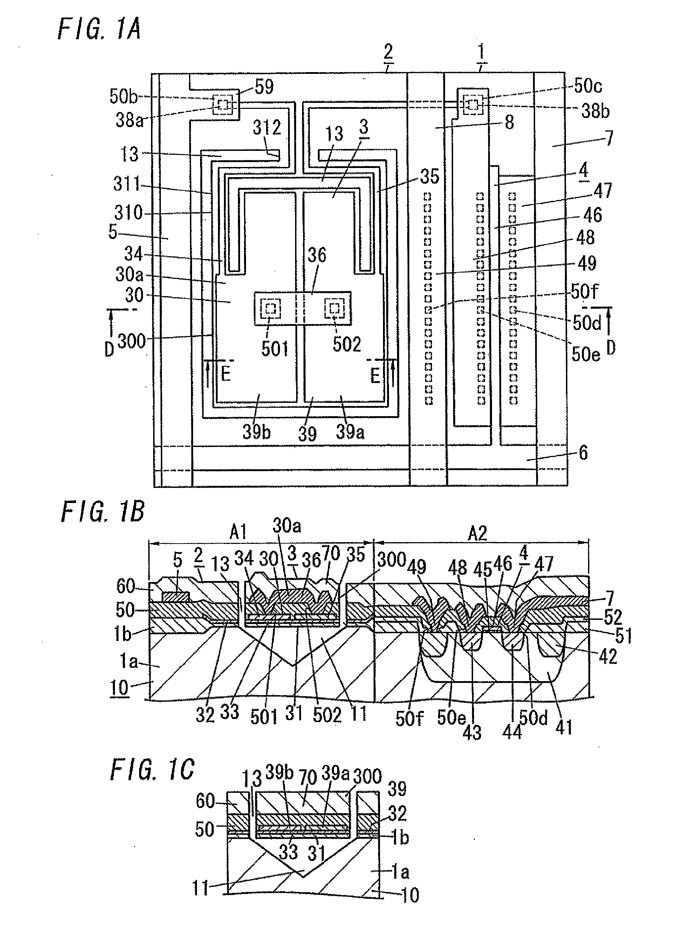

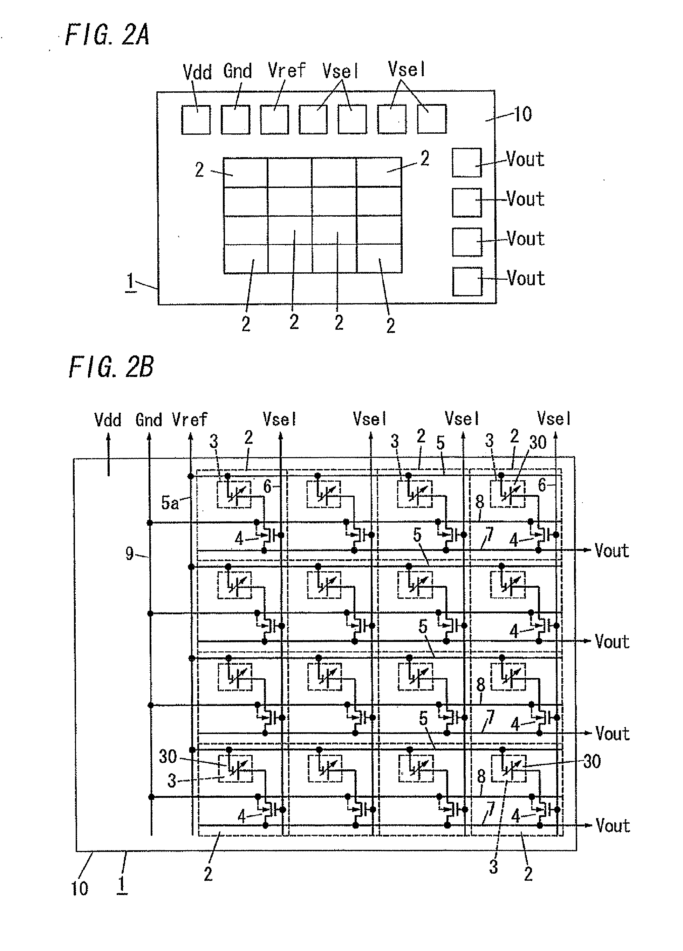

The infrared sensor **1** of the present embodiment is an infrared image sensor (infrared array sensor). As shown in FIGS. 1 and 2, the infrared sensor **1** includes a base (base substrate) **10** used as a basement, and a plurality of cells (pixels) **2** arranged on a first surface (upper surface, in FIG. 1B) of the base **10** in an array (two dimensional array, in the illustrated instance) manner. The cell **2** includes a thermal type infrared detection element **3** including an infrared absorption member **33** and a temperature detection member **30**, and a MOS transistor **4** defined as a switching element for pixel selection.

In the present embodiment, m by n (4 by 4, in the illustrated instance) pixels **2** are formed on the first surface of the single base **10**. The number, arrangement, or both of the pixels 2 is not limited to the present embodiment. Besides, in FIG. 2B, an equivalent circuit of the temperature detection member **30** is illustrated as a power source.

The infrared sensor **1** includes a plurality of vertical read-out lines **7**, a plurality of horizontal signal lines **6**, a plurality of ground lines **8**, a common ground line **9**, a plurality of reference bias lines **5**, and a common reference bias line **5a**. Each of the vertical read-out lines **7** is connected to first ends of the temperature detection members **30** of the plural infrared detection elements **3** in a row via the corresponding MOS transistors **4**. Each of the horizontal signal lines **6** is connected to gate electrodes **46** of the MOS transistors **4** corresponding to the temperature detection members **30** of the infrared detection elements **3** in a column. Each of the ground lines **8** is connected to p-type well regions **41** of the MOS transistors **4** in a row. The common ground line **9** is connected to each of the ground lines **8**. Each of the reference bias lines 5 is connected to second ends of the temperature detection members **30** of the plural infrared detection elements **3** in a row. The common reference bias line **5a** is connected to each of the reference bias lines **5**.

According to the infrared sensor 1, it is enabled to read out a time-series data of the outputs from the temperature detection members **30** of all the infrared detection elements **3**. Further, in the infrared sensor **1**, the plural pixels **2** are formed on the first surface of the base **10**. Each of the pixels **2** includes an infrared detection element **3**, and a MOS transistor **4** which is juxtaposed to the corresponding infrared detection element **3** and is configured to read out an output of the same infrared detection element **3**. The MOS transistor **4** has its gate electrode **46** connected to the horizontal signal line **6**, its source electrode **48** connected to the reference bias line **5** via the temperature detection member **30**, and its drain electrode **47** connected to the vertical read-out line **7**.

Additionally, the infrared sensor **1** includes, plural pixel selection pads **Vsel**, plural output pads **Vout**, a ground pad **Gnd**, a reference bias pad **Vref**, and a substrate pad **Vdd**. The horizontal signal lines **6** are electrically connected to the pixel selection pads **Vsel**, respectively. The vertical read-out lines **7** are electrically connected to the output pads **Vout**, respectively. The common ground line **9** is electrically connected to the ground pad **Gnd**. The common reference bias line **5a** is electrically connected to the reference bias pad **Vref**. The substrate pad **Vdd** is electrically connected to a silicon substrate **1a**.

According to the infrared sensor **1**, by controlling potentials of the pixel selection pads **Vsel** to sequentially turn on the MOS transistors **4**, it is enabled to read out sequentially output voltages from the pixels **2**. For example, when a potential of 5V is applied to the pixel selection pad **Vsel** while potentials of 1.65V, 0V, and 5V are applied to the reference bias pad **Vref**, the ground pad **Gnd**, and the substrate pad Vdd, respectively, the MOS transistor **4** is turned on. As a result, the output pad **Vout** outputs the output voltage (1.65V + an output voltage of the temperature detection member **30**) of the pixel **2**. In brief, it is possible to read out the output voltage of the temperature detection member **30**. In contrast, when the electrical potential of the pixel selection pad **Vsel** is set to 0V, the MOS transistor **4** is turned off. Thus, the output pad **Vout** does not output the output voltage of the pixel **2**.

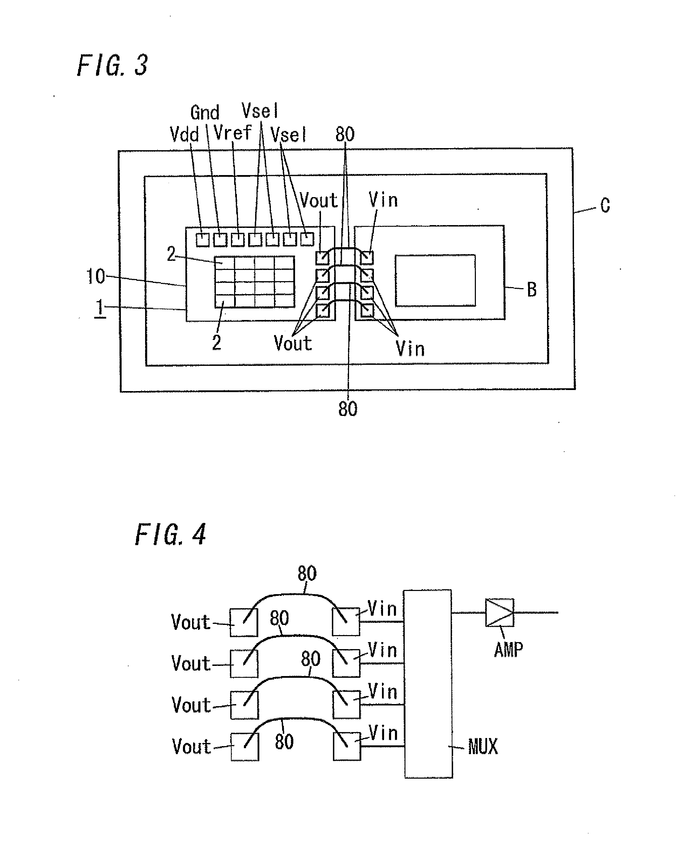

The infrared sensor **1** is applied to an infrared sensor module shown in FIG. 3. The infrared sensor module includes the infrared sensor **1**, a signal processing device (signal processing IC chip) **B** configured to process an output signal (output voltage) of the infrared sensor **1**, and a package **C** on which the infrared sensor **1** and the signal processing device **B** are mounted.

As shown in FIG. 4, the signal processing device **B** includes plural (four, in the illustrated instance) input pads Vin. The input pads **Vin** are electrically connected to the plural (four, in the illustrated instance) output pads **Vout** by use of lines **80** being bonding wires, respectively. Further, the signal processing device **B** includes amplifier circuit **AMP** configured to amplify an output voltage from the input pad Vin, and a multiplexer **MUX** configured to input selectively the output voltages from the input pads Vin into the amplifier circuit **AMP**. Further, the signal processing device includes amplifier circuit configured to amplify an output voltage from the input pad, and a multiplexer configured to supply selectively the output voltages from the input pads to the amplifier circuit. With use of the signal processing device **B**, it is possible to generate an infrared image.

The package **C** is formed into a rectangular box shape and is provided with an opening in its surface (upper surface). The infrared sensor 1 and the signal processing device **B** are mounted (installed) on an inner bottom surface of the package **C**. A package lid (not shown) is attached to the package **C** to cover the opening. The package lid is provided with a lens converging infrared to the infrared absorption member 33 of the infrared detection element **3**.

In the aforementioned infrared sensor module, the base **10** of the infrared sensor **1** is formed to have a rectangular shaped outer periphery. All the output pads **Vouf** configured to read out the output signal from the temperature detection member **3** are arranged on an end portion of a first side of the outer periphery of the base **10** in line along the first side. The signal processing device **B** is formed to have a rectangular shaped outer periphery. All the input pads **Vin** respectively connected to the output pads **Vout** of the infrared sensor 1 are arranged on an end portion of a second side of the outer periphery of the signal processing device **B** in line along the second side. The infrared sensor **1** is mounted on the package **C** such that the second side of the signal processing device **B** is closer to the first side of the base **10** than any other sides of the signal processing device **B.** Therefore, it is possible to shorten the lines **80** respectively connecting the output pads **Vout** of the infrared sensor 1 to the input pads **Vin** of the signal processing device **B**. Consequently, an influence cause by an external noise can be reduced and therefore noise resistance can be improved.

The following explanation is made to a construction of the infrared sensor **1**.

The base **10** is made of the silicon substrate **1a**. For example, the silicon substrate **1a** is a monocrystalline silicon substrate in which a conductivity type is n type and a main surface (upper surface, in FIG. 1 B) is a (100) surface. Further, the silicon substrate **1a** is provided with cavities **11** for thermal insulation in its portions respectively corresponding to the infrared detection members **33**. The cavity **11** has a rectangular shaped inner periphery.

The main surface of the silicon substrate **1a** includes areas **A1** each for forming the infrared detection element **3** of the pixel **2**, and areas **A2** each for forming the MOS transistor **4** of the pixel **2**.

The infrared detection 3 is defined by a thin film structure **300** including the infrared absorption member **33**. The infrared absorption member **33** is formed over the first surface of the base **10** made of the silicon substrate **1a** and is placed to be spatially separated from the base **10**. Further, the thin film structure **300** includes support members (bridges) **310** connecting the base **10** to the infrared absorption member **33**. The support member **310** includes a first connection piece **311** and a second connection piece **312**. The first connection piece **311** is formed into a U shape, and has its two legs connected to the infrared absorption member **33**. The first connection piece **311** is arranged along an outer periphery of the infrared absorption member **33**. The second connection piece **312** extends from a center of a central portion of the first connection piece **311** to an opposite side from the infrared absorption member **33**, and is connected to the base **10.** Besides, the support member **310** includes connection portions respectively connected to the infrared absorption member **33** and the base **10**, and remaining potions spatially separated from both the infrared absorption member **33** and the base **10** by use of two slits **13**. Each of the slits **13** has a width in a range of about 0.2 µm to about 5 µm, for example. As described in the above, the support member **310** is connected to the infrared absorption member **33** only at two points, and is connected to the base **10** only at one point. Since the support member **310** is connected to the base **10** only at one point, it is possible to prevent deformation of the thin film structure **300** even if the base **10** is deformed by an external stress, a thermal stress, or the like. Accordingly, it is possible to reduce a change in sensitivity of the infrared sensor caused by an external stress, a thermal stress, or the like, and therefore it is possible to improve accuracy. Besides, the base **10** has a rectangular frame shaped portion which surrounds the thin film structure.

The thin film structure **300** is formed by patterning a laminate structure including a silicon dioxide film 1 b, the silicon nitride film **32**, the temperature detection member **30**, an interlayer dielectric film **50**, and a passivation film **60**. The silicon dioxide film **1b** is formed on the main surface of the silicon substrate **1a**. The silicon nitride film **32** is formed on the silicon dioxide film **1b**. The temperature detection member **30** is formed on the silicon nitride film **32**. The interlayer dielectric film **50** is made of a BPSG film formed over the silicon nitride film **32** to cover the temperature detection member **30**. In the present embodiment, the interlayer dielectric film **50** has a film thickness of 0.8 µm (8000 Å). The passivation film **60** is a laminated film including a PSG formed on the interlayer dielectric film **50**, and an NSG film formed on the PSG film. In the present embodiment, the PSG film has a film thickness of 5000 Å, and the NSG film has a film thickness of 5000 Å. Therefore, the passivation film **60** has a film thickness of 1 µm. Besides, the passivation film **60** is not limited to the laminated film of the PSG film and the NSG film, but may be a silicon nitride film, for example.

The infrared sensor 1 of the present embodiment is configured to realize the infrared absorption member **33** in the silicon nitride film **32** at a portion except for the support member **310** of the thin film structure **300**. The base **10** is constituted by the silicon substrate **1a**, the silicon dioxide film **1b**, the silicon nitride **32**, the interlayer dielectric film **50**, and the passivation film **60**. Therefore, the passivation film **60** has a top surface which defines the first surface of the base **10**.

A laminated film of the interlayer dielectric film **50** and the passivation film **60** is formed over the area **A1** and the area **A2**. This laminated film has its portion which is formed over the area **A1** and functions as an infrared absorption film **70**. This infrared absorption film **70** has its thickness **t**₂ of **λ/4n**₂, wherein **λ** denotes a center wavelength of infrared to be detected by the infrared detection element **3** and **n**₂ denotes a reflective index of the infrared absorption film **70**. With this arrangement, it is possible to enhance absorption efficiency of the infrared absorption film **70** for infrared having a detection target wavelength (e.g., 8 to 12 µm), and therefore the sensitivity can be improved. For example, when n₂ is 1.4 and A is 10 µm, t₂ is about 1.8 µm. Besides, the infrared absorption film 70 may be made of a silicon nitride film.

The temperature detection member **30** is configured to measure a temperature difference between the infrared absorption member **33** and the base **10**. The temperature detection member **30** includes a thermocouple **30a** defining a temperature detection element. The thermocouple **30a** is made of a p-type polysilicon layer **35**, an n-type polysilicon layer **34**, and a connection layer **36**. The p-type silicon layer **35** is formed over the infrared absorption member **33** and the base **10**. The n-type silicon layer **34** is formed over the infrared absorption member **33** and the base **10** without contact with the p-type polysilicon layer **35**. The connection layer **36** connects the p-type polysilicon layer **35** to the n-type polysilicon layer **34** over an infrared incident surface (upper surface, in FIG. 1 B) defined by an opposite surface of the infrared absorption member **33** from the base **10** (silicon substrate **1a**), that is, over the infrared absorption member **33**.

In more detail, the n-type polysilicon layer **34** and the p-type polysilicon layer **35** are formed on the silicon nitride **32** to be positioned over the infrared absorption member **33**, the support member **33**, and the base **10**. The connection layer **36** is made of a metal material (e.g., Al-Si), and electrically connects a first end of the n-type polysilicon layer **34** and a first end of the p-type polysilicon layer **35** above a center of a top surface of the infrared absorption member **33**. The temperature detection member **30** includes an electrode **38a** formed on a second end of the n-type polysilicon layer **34**, and an electrode 38b formed on a second end of the p-type polysilicon layer **35**.

The interlayer dielectric film **50** isolates and separates the connection layer **36**, the electrode **38a**, and the electrode **38b** from the others. The connection layer **36** is electrically connected to the first end of the n-type polysilicon layer **34** via a contact hole **501** formed in the interlayer dielectric film **50**, and is electrically connected to the first end of the p-type polysilicon layer **35** via a contact holes **502** formed in the interlayer dielectric film **50**. The electrode **38a** is electrically connected to the second end of the n-type polysilicon layer **34** via a contact hole **50b** formed in the interlayer dielectric film **50**. The electrode **38b** is electrically connected to the second end of the p-type polysilicon layer **35** via a contact hole **50c** formed in the interlayer dielectric film **50**.

The safeguard film **39** serves to protect the infrared absorption member **33** and prevent a warp of the infrared absorption member **33** at the time of forming the p-type polysilicon layer **35** and the n-type polysilicon layer **34**. This safeguard film **39** is a polysilicon layer formed on the infrared incident surface of the infrared absorption member **33** to cover the infrared incident surface, and comprises a p-type safeguard film (p-type safeguard polysilicon layer) **39a,** and an n-type safeguard film (n-type safeguard polysilicon layer) **39b**. The p-type safeguard film **39a** and the n-type safeguard film **39b** are arranged not to contact with each other.

The p-type safeguard film **39a** has the p-type impurity (e.g., boron) of the same kind and the same impurity concentration (e.g., 10¹⁸ to 10²⁰ cm⁻³) as the p-type polysilicon layer **35**. In the present embodiment, the p-type safeguard film **39a** is integrally formed with the p-type polysilicon layer **35**. The n-type safeguard film **39b** has the n-type impurity (e.g., phosphorus) of the same kind and the same impurity concentration (e.g., 10¹⁸ to 10²⁰ cm⁻³) as the n-type polysilicon layer **34**. In the present embodiment, the n-type safeguard film **39b** is integrally formed with the n-type polysilicon layer **34**.

As described in the above, the safeguard film **39** constituted by the p-type safeguard film **39a** formed integrally with the p-type polysilicon layer **35** and having an impurity concentration in a range of 10¹⁸ to 10²⁰ cm⁻³, and the n-type safeguard film **39b** formed integrally with the n-type polysilicon layer **34** and having an impurity concentration in a range of 10¹⁸ to 10²⁰ cm⁻³. Accordingly, it is possible to reduce a resistance of the thermocouple **30a** and therefore an S/N ration can be improved.

The p-type polysilicon layer **35**, the n-type polysilicon layer **34**, and the safeguard film **39** (the p-type safeguard film **39a** and the n-type safeguard film **39b**) have the same thickness.

The safeguard film **39** has its thickness t₁ of λ/4n₁, wherein n₁ denotes a reflective index of the safeguard film **39** (i.e., reflective indices of the p-type polysilicon layer **35**, the n-type polysilicon layer **34**, and each of the safeguard films **39**a and **39b**) and A denotes a center wavelength of infrared to be detected by the infrared detection element **3** (infrared to be absorbed by the p-type polysilicon layer **35**, the n-type polysilicon layer **34**, and each of the safeguard films **39a** and **39b**). With this arrangement, it is possible to enhance absorption efficiency of each of the p-type polysilicon layer **35**, the n-type polysilicon layer **34**, and the safeguard films **39**a and **39b** for infrared having a detection target wavelength (e.g., 8 to 12 µm), and therefore the sensitivity can be improved. For example, when n₁ is 3.6 and λ is 10 µm, **t₁** is about 0.69 µm.

Each of the safeguard films **39a** and **39b** has an impurity concentration in a range of 10¹⁸ to 10²⁰ cm⁻³. The p-type polysilicon layer **35** has the impurity of the same kind and the same concentration as the p-type safeguard film **39a**. The n-type polysilicon layer **34** has the impurity of the same kind and the same concentration as the n-type safeguard film **39b**. Each of the polysilicon layers **34** and **35** has an impurity concentration in a range of 10¹⁸ to 10²⁰ CM⁻³. Thus, as disclosed in the above document 2, an absorptance for infrared can be increased, and the reflection of the same infrared can be suppressed. Therefore, an S/N ratio of an output of the temperature detection member **30** is improved. Further, the p-type safeguard film **39a** and the p-type polysilicon layer **35** can be formed through the same process, and the n-type safeguard film **39b** and the n-type polysilicon layer **34** can be formed through the same process. Thus, it is possible to reduce a production cost of the infrared sensor. Besides, with a situation where one of the p-type polysilicon layer **35** and the n-type polysilicon layer **34** has an impurity concentration in a range of 10¹⁸ to 10²⁰ cm⁻³, the S/N ratio of the output of the temperature detection member **30** is improved. Further, with a situation where each of the p-type polysilicon layer **35** and the n-type polysilicon layer **34** has an impurity concentration in a range of 10¹⁸ to 10²⁰ cm⁻³, the S/N ratio of the output of the temperature detection member **30** is more improved. In addition, by selecting the p-type safeguard film **39a** and the p-type polysilicon layer **35** having the impurity of the same kind and the same concentration, or by selecting the n-type safeguard film **39b** and the n-type polysilicon layer **34** having the impurity of the same kind and the same concentration, it is possible to reduce the production cost.

The MOS transistor **4** includes a p-type well region **41**, n⁺-type drain region **44**, n⁺-type source region **43**, p⁺-type channel-stopper region **42**, a gate insulation film **45**, the gate electrode **46**, the drain electrode **47**, the source drain **48**, and a ground electrode **49**. The p-type well region **41** is formed on the main surface of the silicon substrate **1a**. The n⁺-type drain region **44** and the n⁺-type source region **43** are formed in the p-type well region **41** so as to be separated from each other. The p⁺-type channel-stopper region **42** is formed in the p-type well region **41** to surround both n⁺-type the drain region **44** and the n⁺-type source region **43**. The gate insulation film **45** is made of a silicon dioxide film (thermally-oxidized film). The gate insulation film **45** is formed on a part of the p-type well region 41 so as to be placed between the n⁺-type drain region **44** and the n⁺-type source region **43**. The gate electrode **46** is made of an n-type polysilicon layer, and is formed on the gate insulation film **45.** The drain electrode **47** is made of a metal material (e.g., Al-Si), and is formed over the n⁺-type drain region **44**. The source electrode **48** is made of a metal material (e.g., Al-Si), and is formed over the n⁺-type source region **43**. The drain electrode **47** is electrically connected to the n⁺-type drain region **44** via a contact hole **50d** formed in the interlayer dielectric film **50**. The source electrode **48** is electrically connected to the n⁺-type source region **43** via a contact hole **50e** formed in the interlayer dielectric film **50**. The interlayer dielectric film **50** isolates and separates the gate electrode **46**, the drain electrode **47**, and the source electrode **48** from the others. The ground electrode **49** is made of a metal material (e.g., Al-Si), and is formed over the p⁺-type channel-stopper region **42**. The ground electrode **49** is electrically connected to the p⁺-type channel-stopper region **42** via a contact hole **50f** formed in the interlayer dielectric film **50**. The ground electrode **49** is used to give lower potential to the p⁺-type channel-stopper region **42** than (that given) to the n⁺-type drain region **44** and the n⁺-type source region **43** for mutual isolation of the elements (for isolating the element from each other).

In each pixel **2**, the electrode **38b** of the temperature detection member **30** is electrically connected to the source electrode **48** of the MOS transistor **4**, and the electrode **38a** of the temperature detection member **30** is electrically connected to the reference bias line **5** by use of a metal line (e.g., Al-Si line) **59**. The metal line **59** is formed integrally with the reference bias line **5**. Further, in each pixel **2**, the drain electrode **47** of the MOS transistor **4** is electrically connected to the vertical read-out line **7**, and the gate electrode **46** is electrically connected to the horizontal signal line **6**. The horizontal signal line **6** is an n-type polysilicon line formed integrally with the gate electrode **46**. Further, the ground electrode **49** is electrically connected to the common ground line **8**.

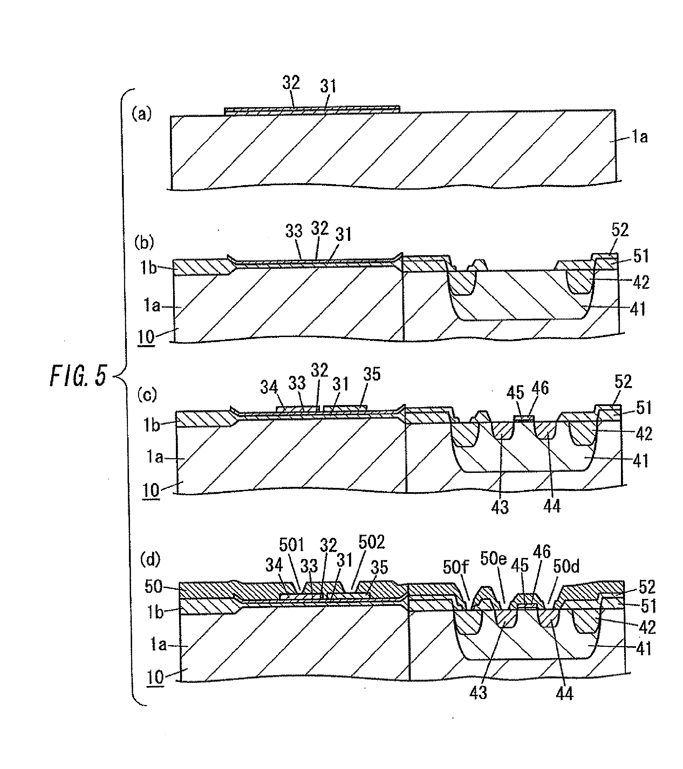

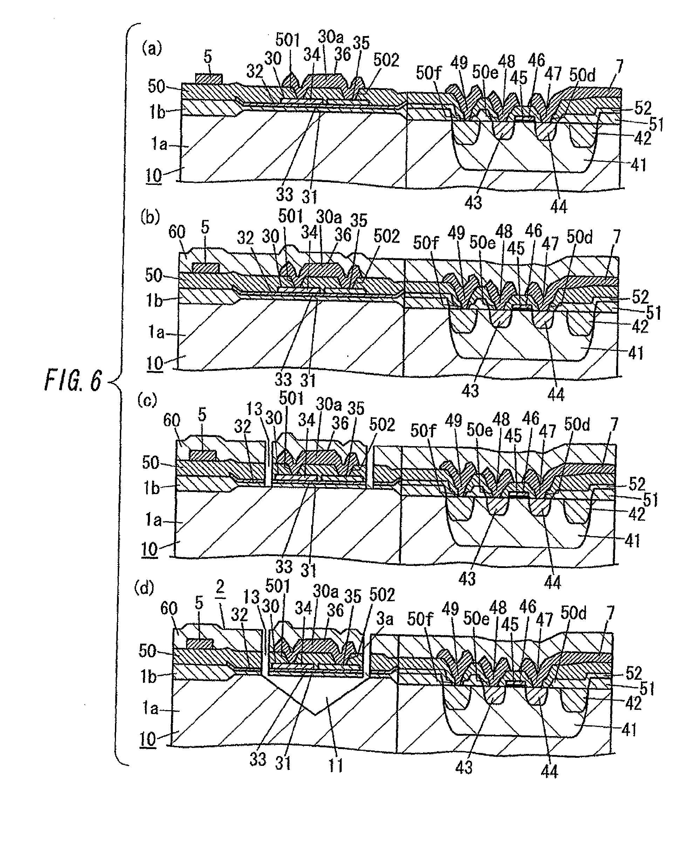

The following brief explanation is made to a method for manufacturing the infrared sensor 1, referring FIGS. 5 and 6.

First, an insulation layer forming step is performed. In the insulation layer forming step, an insulation layer is formed on the main surface of the silicon substrate **1a**. The insulation layer is a laminated film of a first silicon dioxide film **31** having a first predetermined film thickness (e.g., 3000Å), and the silicon nitride film **32** having a second predetermined film thickness (e.g., 900Å). The silicon dioxide film **31** is formed by thermally oxidizing the main surface of the silicon substrate **1a** at a predetermined temperature (e.g., 1100 °C). The silicon nitride film **32** is formed by use of an LPCVD technique.

After the insulation layer forming step, an insulation layer patterning step is performed. In the insulation layer patterning step, by use of the photolithography technique and the etching technique, a part of the insulation layer formed on the area **A2** is removed yet a part of the insulation layer formed on the area **A1** remains. Thereby, a structure illustrated in (a) of FIG. 5 is obtained.

After the insulation layer patterning step, a well region forming step is performed. In the well region forming step, the p-type well region **41** is formed in the main surface of the silicon substrate **1a**. In more detail, by thermally oxidizing an exposed area of the main surface of the silicon substrate **1a** at a predetermined temperature, a second silicon dioxide film (thermally-oxidized film) **51** is formed on a desired area of the main surface of the silicon substrate **1a**. Thereafter, the silicon dioxide film **51** is patterned by use of the photolithography technique and the etching technique together with a mask for forming the p-type well region **41**. Subsequently, the p-type well region **41** is formed by means of the ion implantation of a p-type impurity (e.g., boron) followed by the drive-in diffusion.

After the well region forming step, a channel-stopper region forming step is performed. In the channel-stopper region forming step, the p⁺-type channel-stopper region **42** is formed in the p-type well region **41**. In more detail, by thermally oxidizing the main surface of the silicon substrate **1a** at a predetermined temperature, a third silicon dioxide film (thermally-oxidized film) **52** is formed on a desired area of the main surface of the silicon substrate **1a**. Thereafter, the silicon dioxide film **52** is patterned by use of the photolithography technique and the etching technique together with a mask for forming the p⁺-type channel-stopper region **42**. Subsequently, the p⁺-type channel-stopper region **42** is formed by means of the ion implantation of a p-type impurity (e.g., boron) followed by the drive-in diffusion. Besides, the first silicon dioxide film **31**, the second silicon dioxide film **51**, and the third silicon dioxide film **52** constitute the silicon dioxide film **1b**. Thereby, a structure illustrated in (b) of FIG. 5 is obtained.

After the channel-stopper region forming step, a gate insulation film forming step is performed. In the gate insulation film forming step, the gate insulation film **45** made of a silicon dioxide film (thermally-oxidized film) having a predetermined film thickness (e.g., 600Å) is formed on the main surface of the silicon substrate **1a** by means of the thermal oxidization.

After the gate insulation film forming step, a polysilicon layer forming step is performed. In the polysilicon layer forming step, a non-doped polysilicon layer having a predetermined film thickness (e.g., 0.69 µm) is formed on the whole of the main surface of the silicon substrate **1a** by use of an LPCVD technique. The non-doped polysilicon layer is used as a basis for forming the gate electrode **46**, the horizontal signal line **6** (see FIG. 1A), the n-type polysilicon layer **34**, the p-type polysilicon layer **35**, and each of the safeguard films **39a** and **39b**.

After the polysilicon layer forming step, a polysilicon layer patterning step is performed. In the polysilicon layer patterning step, by use of the photolithography technique and the etching technique, the non-doped polysilicon layer is patterned in order to leave portions thereof respectively corresponding to the gate electrode **46**, the horizontal signal line **6**, the n-type polysilicon layer **34**, the p-type polysilicon layer **35**, and each of the safeguard films **39a** and **39b**.

After the polysilicon layer patterning step, a p-type polysilicon layer forming step is performed. The p-type polysilicon layer forming step is defined to perform an ion implantation of a p-type impurity (e.g., boron) to portions of the non-doped polysilicon layer respectively corresponding to the p-type polysilicon layer **35** and the p-type safeguard film **39a**, followed by the drive diffusion, thereby forming the p-type polysilicon layer **35** and the p-type safeguard film **39a**.

After the p-type polysilicon layer forming step, an n-type polysilicon layer forming step is performed. The n-type polysilicon layer forming step is defined to perform an ion implantation of an n-type impurity (e.g., phosphorus) to portions of the non-doped polysilicon layer respectively corresponding to the n-type polysilicon layer **34**, the n-type safeguard film **39b**, the gate electrode **46**, and the horizontal signal line **6**, followed by the drive diffusion, thereby forming the n-type polysilicon layer **34**, the n-type safeguard film **39b**, the gate electrode **46**, and the horizontal signal line **6**. Thereby, a structure illustrated in (c) of FIG. 5 is obtained. Besides, the order of the p-type polysilicon layer forming step and the n-type polysilicon forming layer may be reversed.

After both the p-type polysilicon layer forming step and the n-type polysilicon layer forming step, a source/drain forming step is performed. The source/drain forming step is defined to perform an ion implantation of an n-type impurity (e.g., phosphors) to regions of the p-type well region **41** respectively reserved for forming the n⁺-type drain region **44** and the n⁺-type source region **43**. After that, the drive diffusion is performed to form the n⁺-type drain region **44** and the n⁺-type source region **43**.

After the source/drain forming step, an interlayer dielectric film forming step is performed. In the interlayer dielectric film forming step, the interlayer dielectric film 50 is formed over the main surface of the silicon substrate **1a**. In more detail, the planarized interlayer dielectric film **50** is formed by depositing a BPSG film having a predetermined film thickness (e.g., 8000 Å) over the main surface of the silicon substrate **1a** by use of CVD technique followed by reflowing the deposited BPSG film at a predetermined temperature (e.g. 800°C).

After the interlayer dielectric film forming step, a contact hole forming step is performed. In the contact hole forming step, the contact holes **501, 502, 50b, 50c, 50d, 50e**, and **50f** are formed in the interlayer dielectric film **50** by use of the photolithography technique and the etching technique. Thereby, a structure illustrated in (d) of FIG. 5 is obtained.

After the contact hole forming step, a metal film forming step is performed. In the metal film forming step, over the whole of the main surface of the silicon substrate **1a** is formed, by use of the sputtering, a metal film (e.g., Al-Si film) having a predetermined film thickness (e.g., 2 µm). The above metal film is a basis for forming the connection layer **36**, each of the electrodes **38a** and **38b**, the drain electrode **47**, the source electrode **48**, the reference bias line **5**, the metal line **59**, the vertical read-out line **7**, the ground line **8**, the common ground line **9**, and each of the pads **Vout, Vsel, Vref, Vdd**, and **Gnd**.

After the metal film forming step, a metal film patterning step is performed. In the metal film patterning step, by patterning the metal film by use of the photolithography technique and the etching technique, the connection layer **36**, each of the electrodes **38a** and **38b**, the drain electrode **47**, the source electrode **48**, the reference bias line **5**, the vertical read-out line **7**, the ground line **8**, the common ground line **9**, and each of the pads **Vout, Vsel, Vref, Vdd,** and **Gnd.** Thereby, a structure illustrated in (a) of FIG. 6 is obtained. Besides, in the metal film patterning step, the metal film is etched by use of RIE.

After the metal film patterning step, a passivation film forming step is performed. In the passivation film forming step, the passivation film **60** is formed over the whole of the main surface of the silicon substrate **1a** (in other words, on the interlayer dielectric film **50**) by use of the CVD technique. The passivation film **60** is a laminated film of the PSG film having a predetermined film thickness (e.g., 5000 Å) and the NSG film having a predetermined film thickness (e.g., 5000 Å). Thereby, a structure illustrated in (b) of FIG. 6 is obtained.

After the passivation film forming step, a laminate structure patterning step is performed. In the laminate structure patterning step, the thin film structure is formed by patterning a laminate structure which is composed of the thermal insulation layer defined as a laminate of the silicon dioxide film **31** and the silicon nitride film **32**, the temperature detection member **30** formed on the thermal insulation layer, the interlayer dielectric film **50** formed over the thermal insulation layer to cover the temperature detection member **30**, and the passivation film **60** formed on the interlayer dielectric film **50**. Thereby, a structure illustrated in (c) of FIG. 6 is obtained. Besides, in the laminate structure patterning step, the plural (two, in the present embodiment) slits **13** are formed. Each of the slits **13** is configured to penetrate the laminate structure along a thickness direction thereof and to separate the infrared absorption member **33** from the base **10** is formed. The above laminate structure is completed by forming these slits **13**.

After the laminate structure patterning step, an opening forming step is performed. In the opening forming step, openings (not shown) is formed by use of the photolithography technique and the etching technique. The openings are designed to expose the pads Vout, **Vsel, Vref, Vdd,** and **Gnd**, respectively. In the opening forming step, the openings are formed by use of the RIE.

After the opening forming step, a cavity forming step is performed. In the cavity forming step, by making anisotropic etching of the silicon substrate **1a** with an etchant poured into each of the slits **13**, the cavity **11** is formed in the silicon substrate **1a**. Thereby, the infrared sensor **1** in which the pixels **2** are arranged in a two dimensional array manner is obtained, as shown in (d) of FIG. 6. In the cavity forming step, TMAH solution heated to a predetermined temperature (e.g., 85 °C) is used as the etchant. The etchant is not limited to the TMAH solution, but may be alkaline solution (e.g., KOH solution).

Besides, all the steps from the insulation layer forming step to the cavity forming step are performed at wafer level. Therefore, after completion of the cavity forming step, a separation step is made to separate the infrared sensors **1** from each other.

In addition, the MOS transistor **4** is formed by means of a known and common manufacturing method of MOS transistors. In other words, the p-type well region **41**, the p⁺-type channel-stopper region **42**, the n⁺-type drain region **44**, and the n⁺-type source region 43 are formed by repeating basic steps, that is, a step of forming a thermally-oxidized film by use of thermal oxidization, a step of patterning the thermally-oxidized film by use of the photolithography technique and the etching technique, a step of implementing an impurity, and a step of performing drive-in diffusion (diffusion of impurities).

According to the infrared sensor **1** explained in the above, the temperature detection member **30** detects the temperature difference between the infrared absorption member **33** and the base **10** by use of the thermocouple **30a**. Therefore, it is unnecessary to supply electrical current to the temperature detection member **30**. Since the temperature detection member **30** does not heat itself as opposed to the temperature detection member **30** made of a resistive bolometer, the infrared absorption member **33** and also the thin film structure **300** are kept free from a warp which would otherwise occur due to the self-heating of the temperature detection member **30**, thereby contributing to reduce power consumption. Moreover, since the sensitivity is kept constant irrespective of temperature, the accuracy of the infrared sensor is improved. In addition, the safeguard films **39a** and **39b** are formed on the infrared incident surface of the infrared absorption member **33**. Thus, the infrared absorption member **33** can be prevented from being etched to be thinned at the time of forming the p-type polysilicon layer **35** and the n-type polysilicon layer **34**. In brief, in the polysilicon layer patterning step, it is possible to prevent thinning of the silicon nitride film **32** caused by over-etching which may occur at the time of etching the non-doped polysilicon layer. Therefore, it is possible to protect the infrared absorption member **33** at the time of using forming the p-type polysilicon layer **35** and the n-type polysilicon layer **34**. In addition, the safeguard films **39a** and **39b** can enhance uniform distribution of stress in the thin film structure **300**. Consequently, it is possible to make the infrared absorption member **33** thin, yet keeping the thin film structure **300** free from a warp, and therefore it is possible to improve the sensitivity.

The safeguard films **39a** and **39b** are preferred to be formed to cover, in cooperation with the temperature detection member **30**, an approximately entire surface of the infrared absorption member **33.** It is necessary to prevent the safeguard films **39a** and **39b** from being etched by the etchant (e.g., TMAH solution) used in the cavity forming step. Thus, the safeguard films **39a** and **39b** are shaped not to be exposed on an inner aspect of the slit **13**. In brief, the safeguard films **39a** and **39b** are formed not to cover the outer periphery of the infrared absorption member **33**.

In the infrared sensor **1**, the p-type polysilicon layer **35**, the n-type polysilicon layer **34**, and each of the safeguard films **39a** and **39b** have the same thickness. Therefore, the uniform distribution of the stress in the thin film structure **300** can be improved. Thus, it is possible to keep the infrared absorption member **33** free from a warp.

In the infrared sensor **1**, the p-type polysilicon layer **35**, the n-type polysilicon layer **34**, and each of the safeguard films **39a** and **39b** are formed in a common plane. Therefore, the uniform distribution of the stress in the thin film structure **300** can be improved. Thus, it is possible to keep the infrared absorption member **33** free from a warp.

Since the infrared sensor **1** includes the MOS transistor **4** for each pixel **2**, it is possible to reduce the number of the output pads Vout, and therefore it is possible to downsize the infrared sensor **1** and reduce the production cost thereof.

In the infrared sensor **1**, the n-type polysilicon layer which is a polysilicon layer forming the gate electrode **46** of the MOS transistor **4** have the same thickness as the n-type safeguard film **39b**. Therefore, it is possible to form the gate electrode **46** of the MOS transistor **4** and the n-type safeguard film **39b** through the same process. Accordingly, it is possible to reduce the number of the steps of the method for manufacturing the infrared sensor, and therefore it is possible to reduce production cost thereof.

Besides, the infrared sensor 1 may includes the single infrared detection element 3.

### (SECOND EMBODIMENT)

The infrared sensor **1A** of the present embodiment is different from the infrared sensor **1** of the first embodiment in the pixel **2A** and the temperature detection member **30A**. Configurations common to the infrared sensor **1A** and the infrared sensor **1** are designated by the same reference numerals, and no explanations thereof are made.

Each of the pixels **2A** is provided with no MOS transistor **4**.

The temperature detection member **30A** includes the four thermocouples **30a** each of which includes an n-type polysilicon layer **34**, a p-type polysilicon layer **35**, and a connection layer **36**. The second end of the p-type polysilicon layer **35** of the thermocouple **30a** is connected to the second end of the n-type polysilicon layer **34** of the thermocouple **30a** next thereto by use of a connection layer **37** made of a metal material (e.g., Al-Si). As described in the above, the four thermocouples **30a** are connected in series with each other to constitute a thermopile.

The aforementioned thermopile includes hot junctions each constituted by the first end of the n-type polysilicon layer **34**, the first end of the p-type polysilicon layer **35**, and the connection layer **36**, and cold junctions each constituted by the second end of the p-type polysilicon layer **35**, the second end of the n-type polysilicon layer **34**, and the connection layer **37**. The hot junctions are disposed over the infrared absorption member **33**, and the cold junctions are disposed over the base **10**.

The method for manufacturing the infrared sensor **1A** is different from the method for manufacturing the infrared sensor **1** in the laminated structure patterning step and the cavity forming step. In the laminated structure patterning step of the present embodiment, four rectangular slits **14** which penetrate the laminated structure in a thickness direction thereof are respectively formed in four corners of a projected area of an area reserved for forming the cavity **11** of the silicon substrate **1a** in order to form the thin film structure **300**. In the cavity forming step of the present embodiment, the four slits **14** are used as etchant conduits. Besides, since the infrared sensor **1A** is provided with no MOS transistors **4**, the first silicon dioxide film **31** defines the silicon dioxide film **1b** solely.

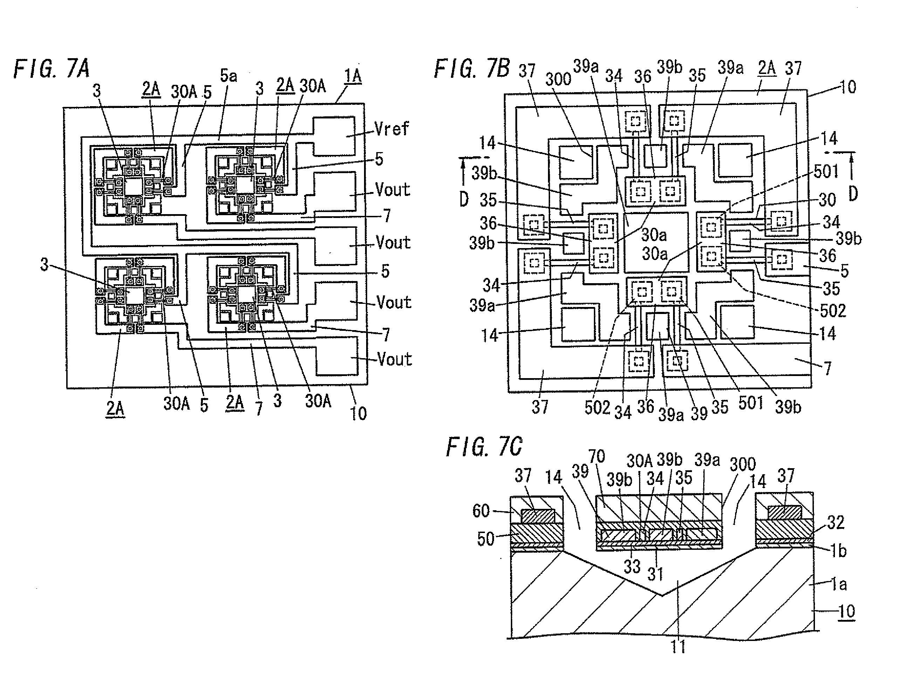

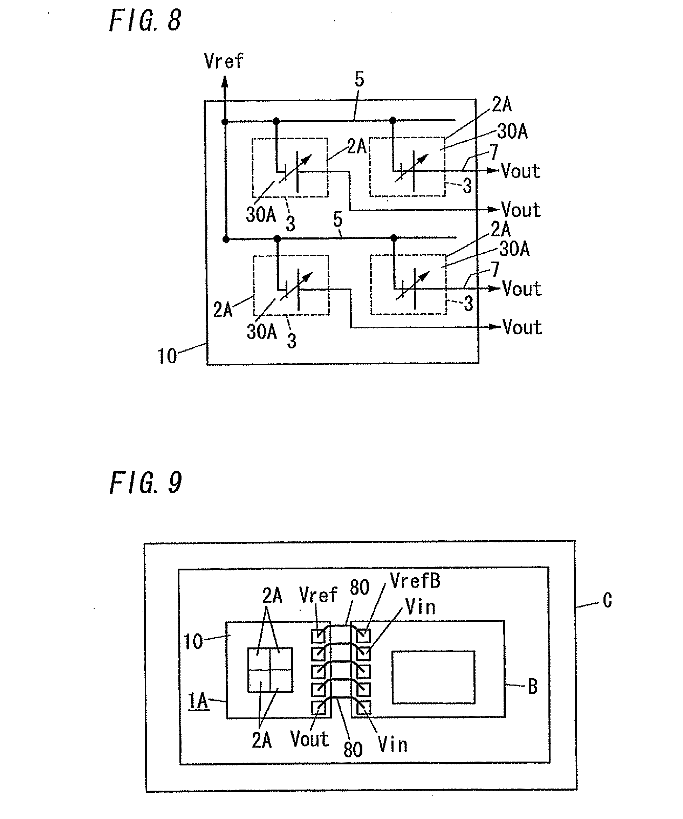

As shown in FIGS. 7 and 8, the infrared sensor **1A** includes the plural (four, in the illustrated instance) output pads **Vout**, and the single reference bias pad **Vref**. The output pads **Vout** are connected to the first ends of the temperature detection members **30**, respectively. For each row, the reference bias pad **Vref** is connected to the second ends of the temperature detection members **30A** of the plural (two, in the illustrated instance) infrared detection elements **3**. According to the infrared sensor **1A**, it is enabled to read out a time-series data of the outputs from all the infrared detection elements **3**. Besides, the temperature detection member **30A** has its first end electrically connected to the output pad **Vout** via the vertical read-out line **7**. The temperature detection member **30A** has its second end electrically connected to the common reference bias line **5a** connected to the reference bias pad **Vref**, by use of the reference bias line **5**. Besides, in FIG. 8, the temperature detection member 3**0A** is illustrated as its equivalent circuit including a voltage source.

For example, while the electrical potential of 1.65 V is applied to the reference bias pad **Vref**, the output pad Vout outputs the output voltage (1.65 V + the output voltage of the temperature detection member **30A**) of the pixel **2A**.

FIG. 9 shows the infrared sensor module including the infrared sensor **1A**, the signal processing device **B** configured to process the output voltage being the output signal of the infrared sensor **1A**, and the package **C** on which the infrared sensor **1A** and the signal processing device **B** are mounted.

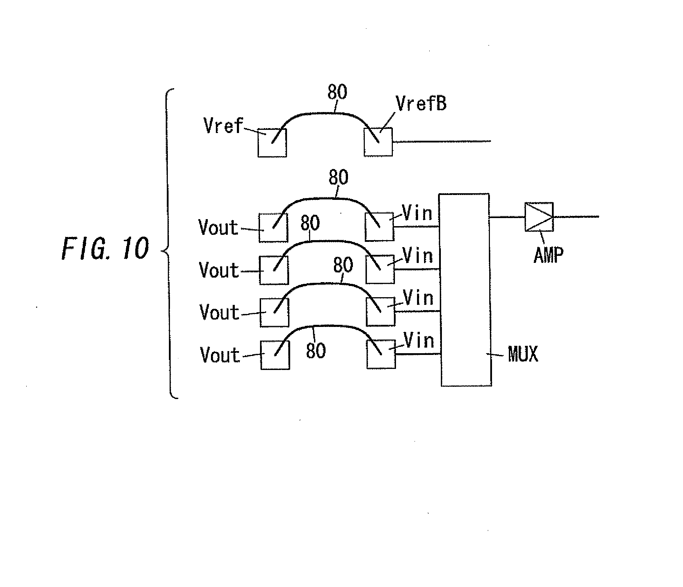

As shown in FIG. 10, the signal processing device **B** includes the plural (four, in the illustrated instance) input pads **Vin**, and a pad **VrefB**. The input pads Vin are electrically connected to the output pads **Vout** of the infrared sensor **1A** by use of lines **80**, respectively. The pad **VrefB** is adapted in use to apply the reference voltage to the reference bias pad **Vref** of the infrared sensor **1A.** The pad **VrefB** is electrically connected to the reference bias pad **Vref** via a line **80**. The signal processing device **B** further includes the amplifier circuit **AMP** and the multiplexer **MUX**. With use of the signal processing device **B**, it is possible to generate an infrared image.

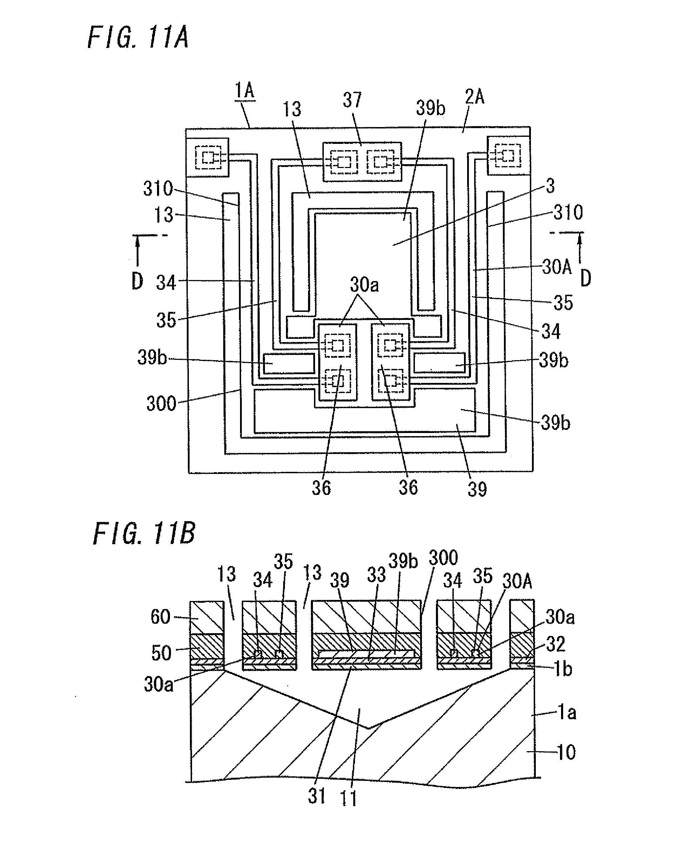

FIG. 11 shows a modification of the infrared sensor **1A** of the present embodiment. In the modification illustrated in the FIG. 11, the temperature detection member **30A** is a thermopile comprising the two thermocouples **30a** connected in series with each other. Further, in the modification, the thin film structure **300** is linked to the base **10** by use of the two support members **310**.

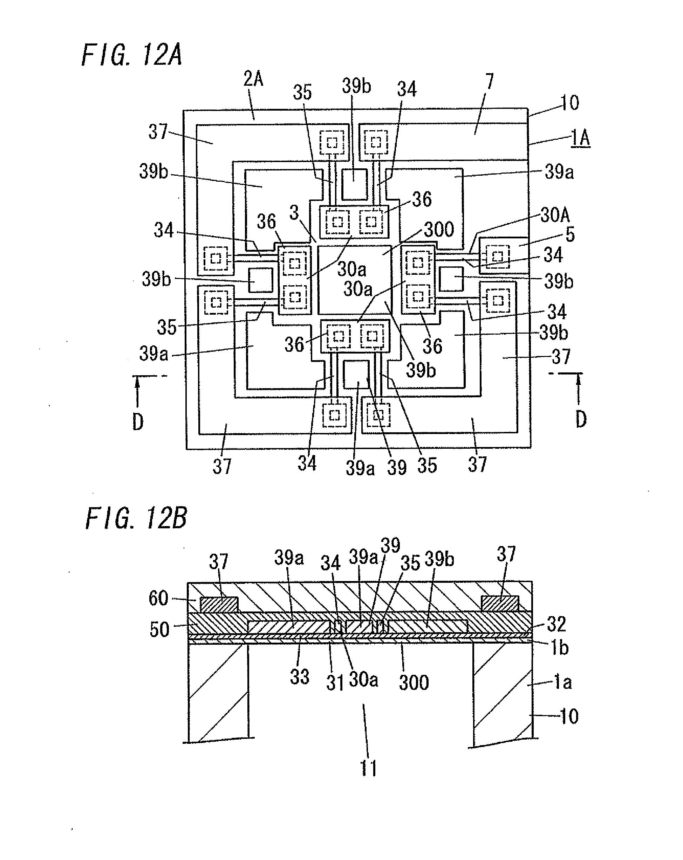

FIG. 12 shows another modification of the infrared sensor **1A**. In the modification illustrated in the FIG. 12, the cavity **11** is formed to penetrate through the silicon substrate **1a** in its thickness direction. In brief, the thin film structure **300** is formed into a diaphragm shape.

### (THIRD EMBODIMENT)

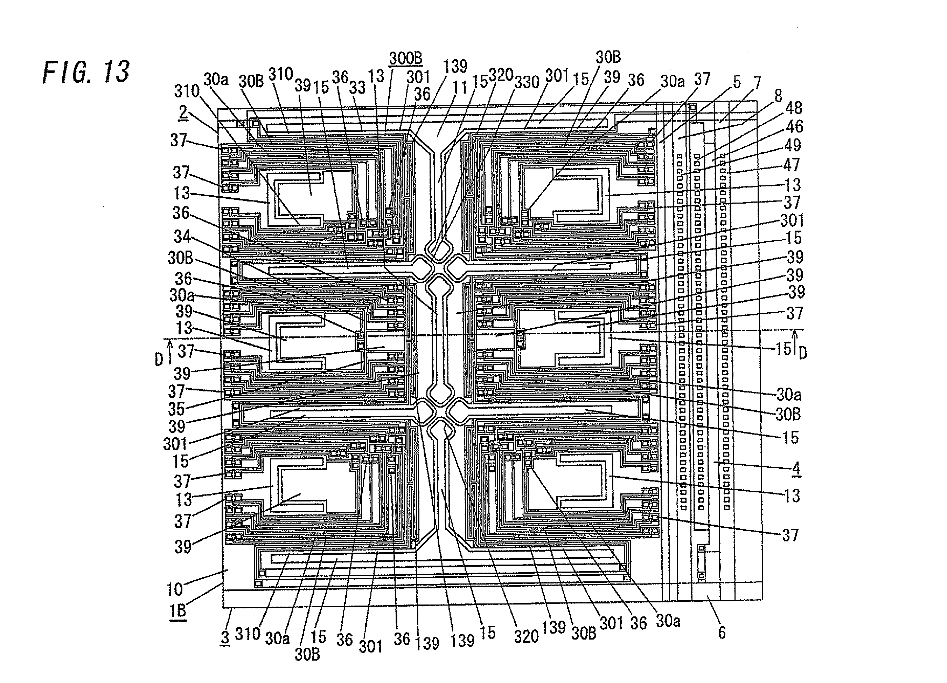

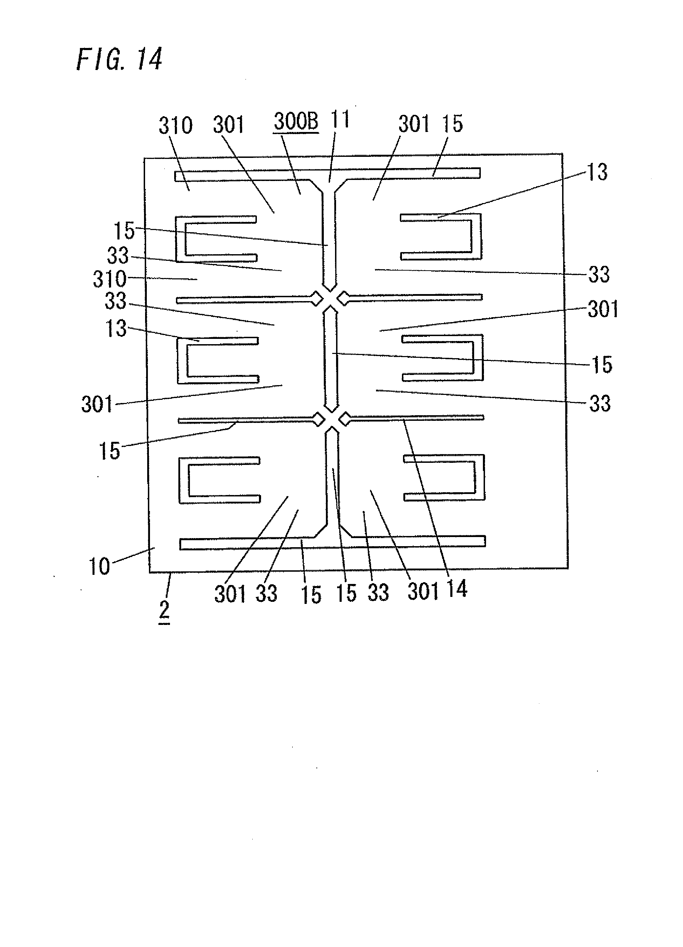

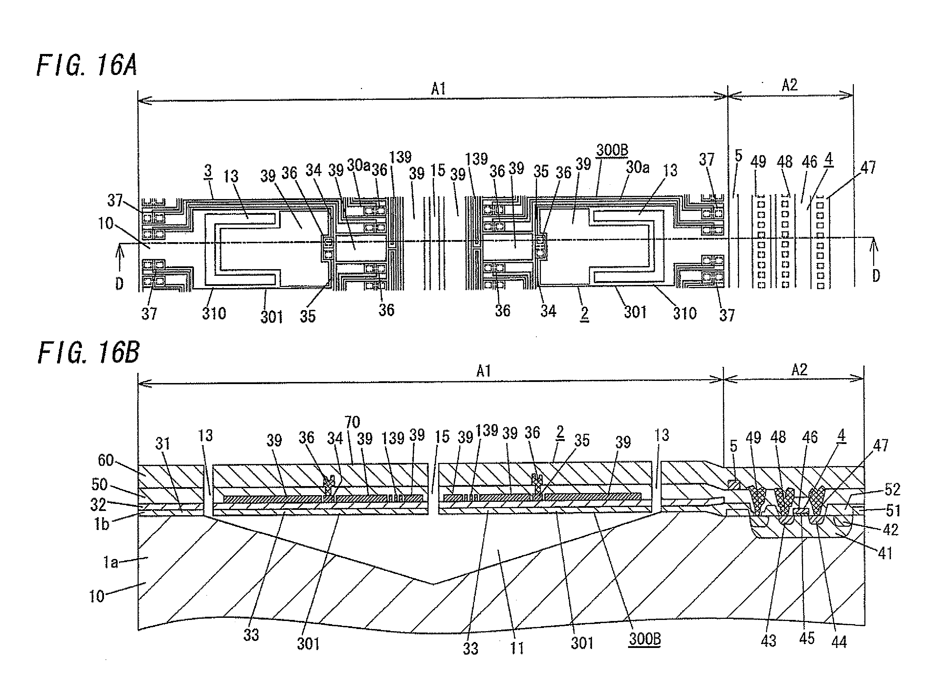

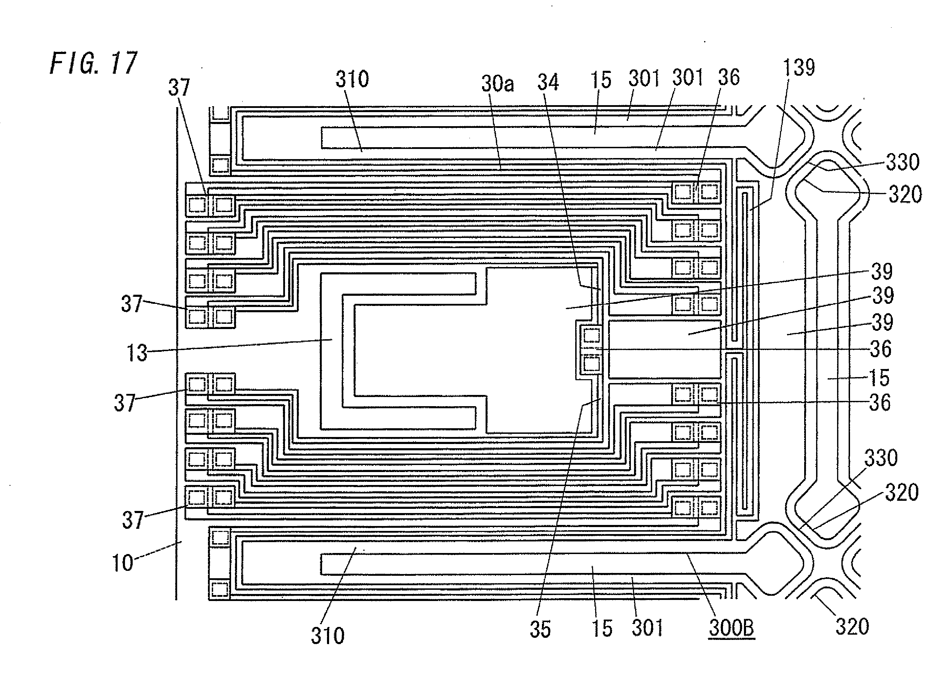

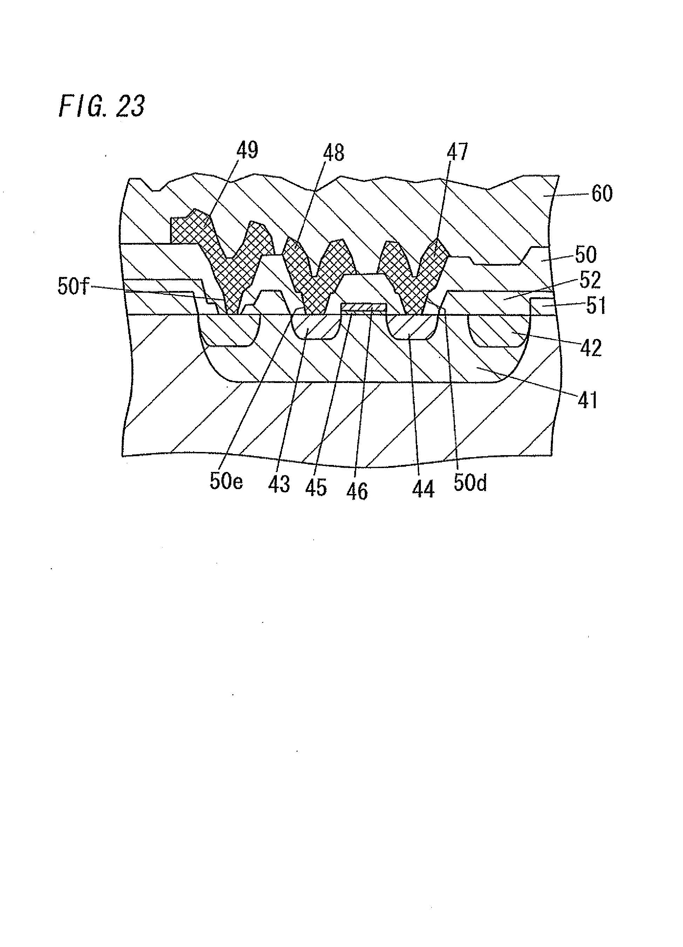

The following explains the infrared sensor **1B** of the present embodiment with reference to FIGS. 13 to 37.

The infrared sensor **1B** of the present embodiment is mainly different from the infrared sensor **1** of the first embodiment in the thin film structure **300B**. Besides, components common to the infrared sensor **1B** and the infrared sensor 1 are designated by the same reference numerals, and no explanations thereof are made.

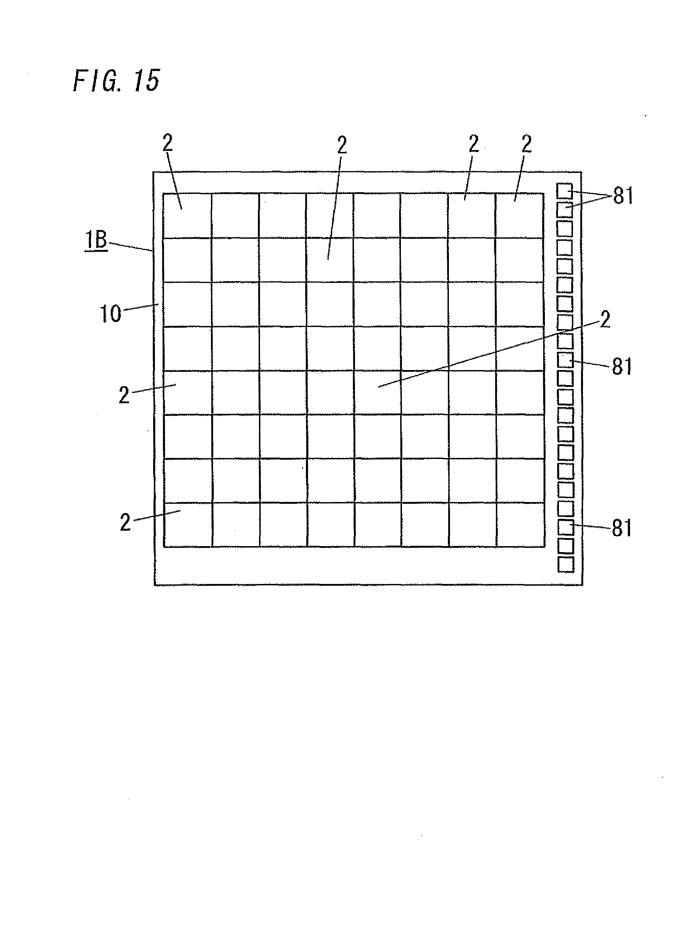

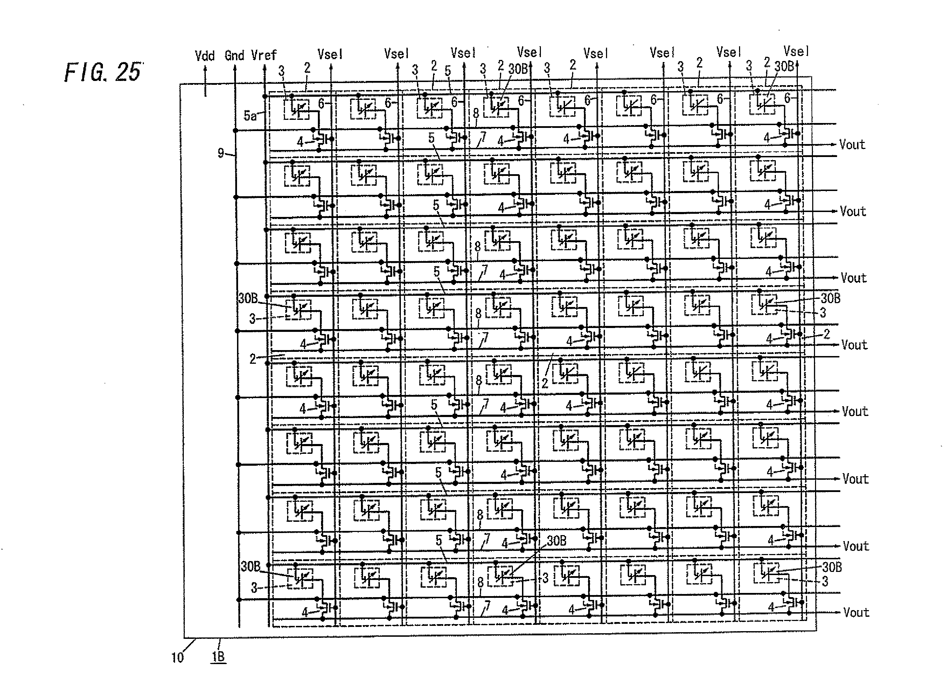

In the infrared sensor **1B**, as shown in FIGS. 15 and 25, the 8 by 8 pixels **2** are formed over the first surface of the single base **10**. The number and arrangement of the pixels **2** are not limited.

Besides, in FIG. 15, the pixel selections **Vsel**, the reference bias pad **Vref**, the ground pad **Gnd**, the output pads **Vout**, and the like are illustrated, with no distinction, as pads **81**.

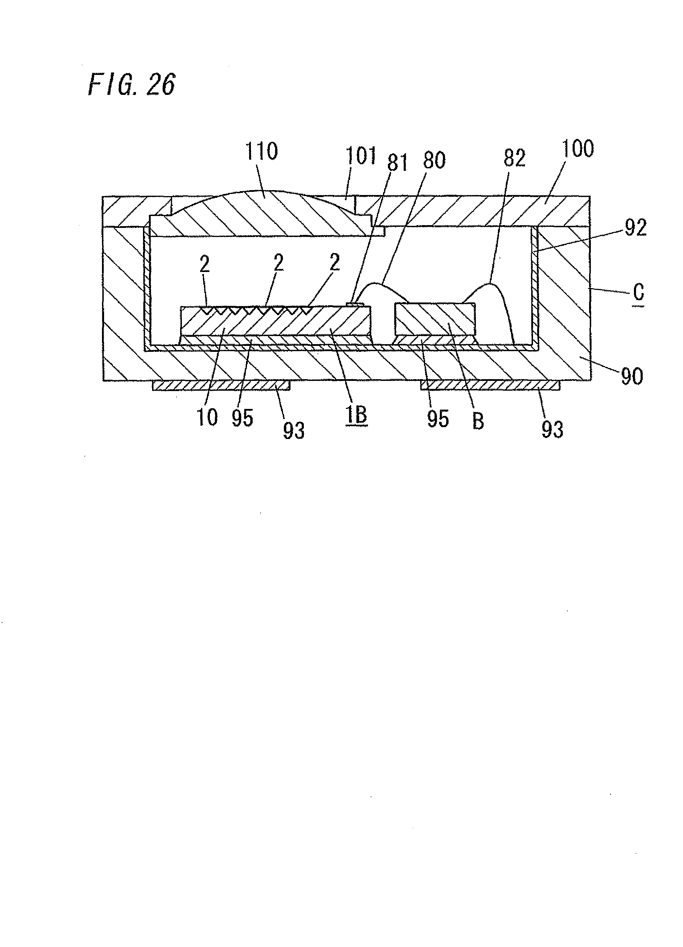

FIG. 26 shows the infrared sensor module including the infrared sensor **1B** (infrared array sensor module). This infrared sensor module includes the infrared sensor 1B, the signal processing device **B** configured to process the output voltage being the output signal of the infrared sensor **1A**, and the package **C** on which the infrared sensor **1A** and the signal processing device **B** are mounted.

The package **C** comprises a package body **90**, and a package lid **100**. The package body **90** is a multilayered ceramic substrate (ceramic package) which is formed into a rectangular box shape and is provided with an opening in its surface (upper surface). The infrared sensor **1B** and the signal processing device **B** are mounted (installed) on an inner bottom surface of the package body **90**. The package lid **100** is a metal lid, and is provided with a lens converging infrared to the infrared sensor **1B**. According to the package **C**, an air tight space surrounded by the package body **90** and the package lid **100** defines a dry nitrogen atmosphere. The package lid has its outer periphery fixed to a rectangular patterned metal (not shown) formed on the surface of the package body **90** by means of seam welding. The package body **90** may be made by superimposing glass epoxy resin substrates.

On an inner surface of the package body **90** is formed a shield patterned conductor **92**. The infrared sensor **1B** and the signal processing device **B** are bonded to the shield patterned conductor **92** by use of junction layers **95** made of an electrically conductive junction material (e.g., solder and silver paste). For example, a method of bonding the infrared sensor **1B** and the signal processing device **B** to the package body **90** can be selected one from normal temperature bonding method, Au-Sn eutectic bonding method, and Au-Si eutectic bonding method. In contrast to a bonding with the use of an electrically conductive material, a direct bonding such as normal temperature bonding can improve accuracy of distance between the infrared sensor **1A** and the lens **110**.

The lens **110** is made of silicon which is one of infrared transparent materials. The lens **110** can be made by use of a method for manufacturing a semiconductor lens using an anode oxidation technique (e.g., methods for manufacturing semiconductor lenses disclosed in Japanese patent publications No. 3897055 and No. 3897056), for example. The lens **110** is fixed, by use of an electrically conductive adhesive (e.g., solder and silver paste), to a periphery of an aperture **101** of the package lid **100** so as to cover the aperture **101** of the package lid **100**. The lens **110** further is electrically connected to the shield patterned conductor **92**. Therefore, the infrared array sensor module can suppress a decrease in the S/N ration caused by external electromagnetic noises. Besides, the lens **110** may be provided with an infrared optical filter, as necessary. The infrared optical filter may be a bandpass filter or a broadband rejection filter. Such an infrared optical filter can be made by alternately superimposing plural kinds of thin films having different refractive indexes.

The thin film structure **300B** is formed to cover the cavity **11** which thermally insulates the infrared absorption member **33** from the base **10**. In the present embodiment, the cavity **11** is formed into a square pyramid shape. Therefore, in a situation where the base **10** is made of the silicon substrate **1a**, the cavity can be easily formed by use of anisotropic etching with alkaline solution.

The thin film structure **300B** is divided into plural (six, in the illustrated instance) small and thin film structures **301** by plural linear slits **15**. In brief, the thin film structure **3008** comprises a plurality of the small and thin film structures **301**. The plural small and thin film structures **301** are arranged in line along a circumference direction of the cavity **11**. Each of the small and thin film structures **301** extends from an edge of the cavity **11** in the base **10** to an inside of the cavity **11**. Each of the small and thin film structures **301** includes an infrared absorption member **33** and a temperature detection member **30B**. As apparent from the above, the thin film structure **300B** includes the plural (six, in the illustrated instance) infrared absorption members **33** arranged inside the cavity **11**. Further, the thin film structure **300B** includes connection members 320 configured to connect together the small and thin film structures **301** and **301** which are adjacent to each other.

Each of the temperature detection members **30B** is disposed over a corresponding infrared absorption member **33**. All the temperature detection members **30B** are electrically connected to each other in such a relation as to provide a temperature-dependent output (output varied by a change in temperature) which is greater than any single one of the temperature detection members **30B**.

In the present embodiment, all the temperature detection members **30B** are connected in series with each other. All the temperature detection members thus connected in series with each other give an overall output which is equal to the sum of thermal electromotive forces of the individual temperature detection members **30B**, and therefore provide the temperature-dependent output which is greater than any single one of the temperature detection members **30B**, thereby improving sensitivity.

Besides, all the temperature detection members **30B** need not be connected in series with each other. For example, two series circuits of three temperature detection members **30B** may be connected in parallel with each other. This arrangement can improve the sensitivity, in contrast to a situation where all the temperature detection members **30B** are connected in parallel with each other or a situation where the temperature detection members **30B** are not connected to each other. Further, it is possible to decrease an electric resistance of an electrical circuit of the six temperature detection members **30B** in contrast to a situation where all the temperature detection members **30B** are connected in series with each other. Thus, a thermal noise can be reduced, and therefore the S/N ratio can be improved.

Further, it is sufficient that the temperature detection member **30B** is a thermal type infrared detection member. Therefore, a pyroelectric element can be adopted as the temperature detection member **30B**. In this situation, to connect the plural temperature detection members **30B** in parallel with each other gives an overall output which is equal to the sum of electric charges generated by pyroelectric effects of individual temperature detection members, and therefore provides the temperature-dependent output which is greater than that of any single one of the temperature detection members **30B**.

The thin film structure **300B** includes, for each small and thin film structure **301**, two support members **310** each connecting the infrared absorption member **33** to the base **10.** The two support members **310** are formed into a strip shape, and are spaced from each other in the circumference direction of the cavity **11**. Further, the thin film structure **300B** is provided with U-shaped slits **13** each of which spatially separates the infrared absorption member **33** from two support members **310** and communicates to the cavity **11**. The base **10** has a rectangular frame-shaped portion surrounding the thin film structure **300B**. The support member **301** has portions respectively connected to the infrared absorption member **33** and the base **10**, and a remaining portion spatially separated from the infrared absorption member **33** and the base **10.** In the present embodiment, the small and thin film structure **301** has a length of 93 µm in an extension direction from the base 10. The small and thin film structure **301** has a width of 75 µm in a width direction which is orthogonal to the extension direction thereof. Each of the support members **310** has a width of 23 µm. Each of the slits **13** and **15** has a width of 5 µm. These values are illustrative only.

The thin film structure **300B** is formed by patterning the laminated structure of the silicon dioxide film **1b**, the silicon nitride film **32**, the temperature detection member **30B**, the interlayer dielectric film **50**, and the passivation film **60** in a similar fashion as the thin film structure **300**.

The connection member **320** is formed into a cross shape, and is configured to connect together the small and thin film structures **301** which are juxtaposed to each other in a diagonal direction crossing the extension direction of the small and thin film structure **301**. Further, the connection member **320** is configured to connect together the small and thin film structures **301** which are juxtaposed to each other in the extension direction of the small and thin film structure **301**. Moreover, the connection member **320** is configured to connect together the small and thin film structures **301** which are juxtaposed to each other in a direction perpendicular to the extension direction of the small and thin film structure **301**.

The temperature detection member **30B** is a thermopile, and includes the plural (nine, in the illustrated instance) thermopiles **30a** connected in series with each other. As described in the second embodiment, the adjacent thermocouples **30a** are electrically connected with each other via the connection layer **37**. Also in the present embodiment, the first end of the n-type polysilicon layer **34**, the first end of the p-type polysilicon layer **35**, and the connection layer **36** constitute the hot junction, and the second end of the n-type polysilicon layer **34**, the second end of the p-type polysilicon layer **35**, and the connection layer **37** constitute the cold junction in a similar fashion as the second embodiment. The hot junctions are disposed over the infrared absorption member **33**, and the cold junctions are disposed over the base 10.

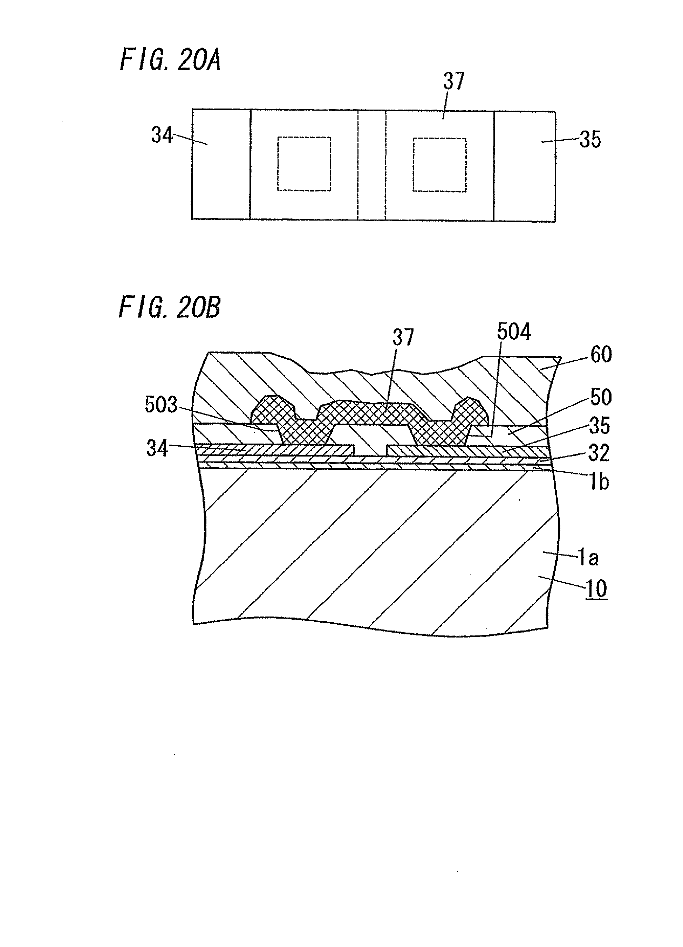

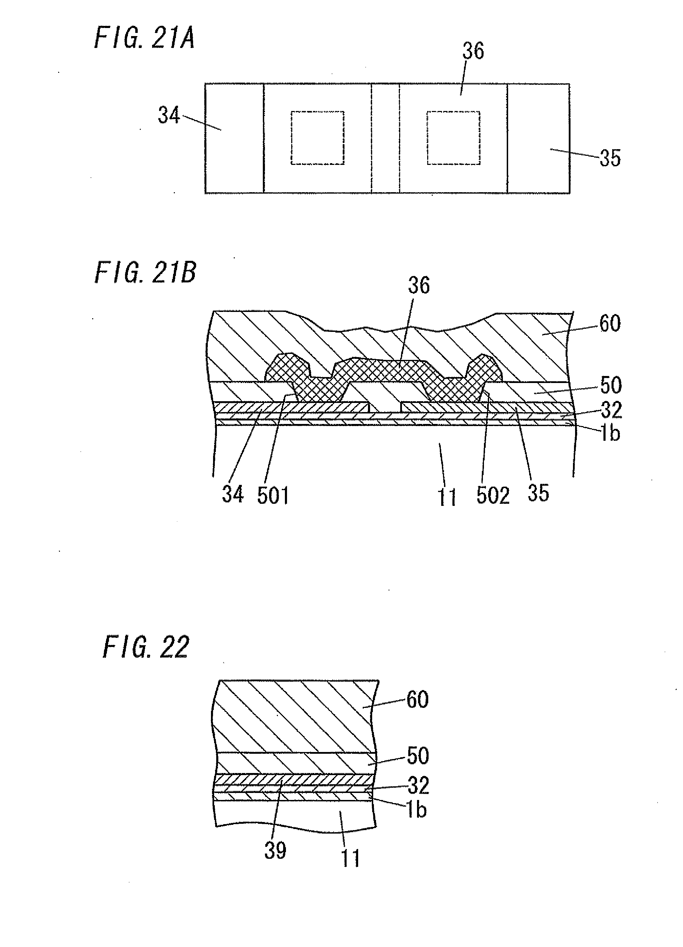

The connection layer **36** and **37** are isolated from each other by the interlayer dielectric fiilm **50** (see FIGS. 20 and 21). In brief, the connection layer **36** of the hot junction is electrically connected to the first ends of both polysilicon layers **34** and **35** via contact holes **501** and **502** formed in the interlayer dielectric film **50**, respectively. The connection layer **37** of the cold junction is electrically connected to the second ends of both polysilicon layers **34** and **35** via contact holes **503** and **504** formed in the interlayer dielectric film **50**, respectively.

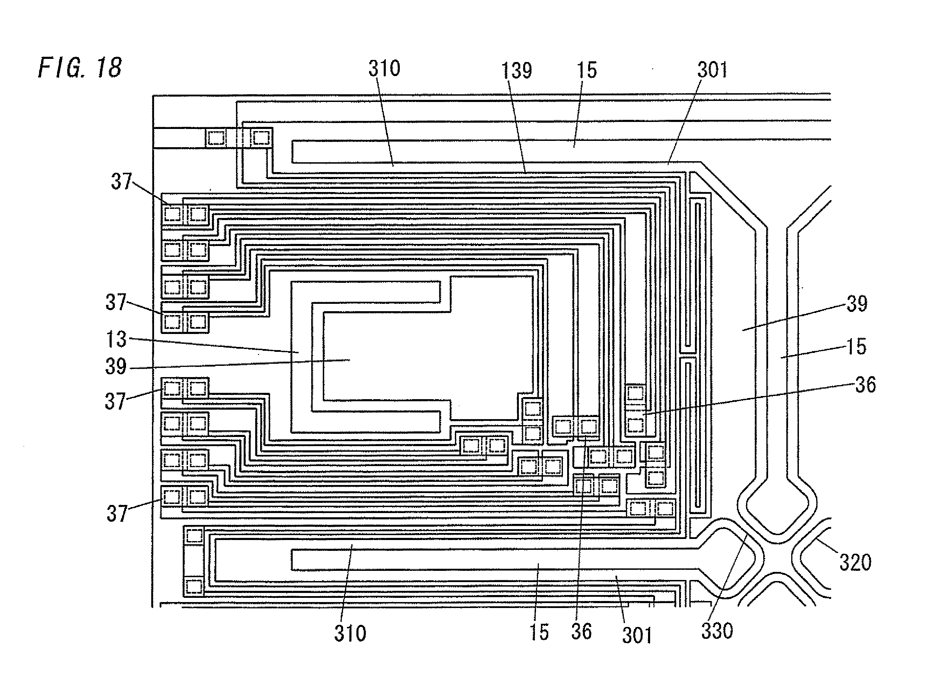

In the infrared sensor **1B** of the present embodiment, the cavity **11** has the square pyramid shape. Therefore, a depth of the cavity **11** is made greater towards its center than at its outer circumference. In view of the above, the temperature detection members **30B** are disposed over the corresponding small and thin film structures **301** such that the hot junctions are herded in a center of the thin film structure **300B**. For example, with respect to the two small and thin film structures **301** in a center in an upward/downward direction of FIG. 13 (direction in which the three small and thin film structures **301** are aligned), the connection layers **36** are arranged along the upward/downward direction as shown in FIGS. 13 and 18. With respect to the two small and thin film structures **301** in an upper side in the upward/downward direction of FIG. 13, the connection layers **36** are herded in a lower side in the upward/downward direction as shown in FIGS. 13 and 18. With respect to the two small and thin film structures **301** in a lower side in the upward/downward direction of FIG. 13, the connection layers **36** are herded in an upper side in the upward/downward direction as shown in FIGS. 13 and 18. This arrangement enables to increase temperature variation at the hot junction, in contrast to a case where the plural connection layers **36** of the small and thin film structures **301** in the upper and lower sides are arranged in the upward/downward direction of FIG. 13 in the same fashion as the plural connection layers **36** of the small and thin film structures **301** are arranged in the center of the upward/downward direction of FIG. 13. Thus, the sensitivity can be improved.

In the small and thin film structure **301**, the safeguard films **39** are formed on an area of the infrared incident surface of the silicon nitride film **32** on which the temperature detection members **30B** are not formed (see FIGS. 13, 16, and 22). The safeguard film **39** is defined as an infrared absorption layer made of an n-type polysilicon layer which absorbs infrared and prevents the small and thin film structure **301** from suffering from a warp.

The connection member **320** is provided with a reinforcement member (reinforcement layer) **330** (see FIG. 13) which reinforces mechanical strength of the connection member **320**. The reinforcement member **330** is integrally formed with the safeguard film **39**. In the infrared sensor **1B** of the present embodiment, since the reinforcement member **330** reinforces the connection member **320**, it is possible to prevent breakage of the infrared sensor caused by a stress due to an external temperature variation or impact at the time of using the infrared sensor **1B**. In addition, the infrared sensor **1B** can be free from breakage at the time of manufacturing the infrared sensor **1B**, and therefore fabrication yield can be improved. Besides, in the present embodiment, the connection member **320** has a length **L1** of 24 µm and a width **L2** of 5 µm, and the reinforcement member **330** has a width **L3** of 1 µm. These values are illustrative only. In the present embodiment, the base **10** is made of the silicon substrate **1a**, and the reinforcement member **330** is made of the n-type polysilicon layer. Therefore, it is necessary to prevent the reinforcement member **330** from being etched at the time of forming the cavity **11**. Thus, the reinforcement member **330** is preferred to have a width smaller than that of the connection member **320** such that the reinforcement member **330** is disposed between opposite width ends of the connection member **320**.

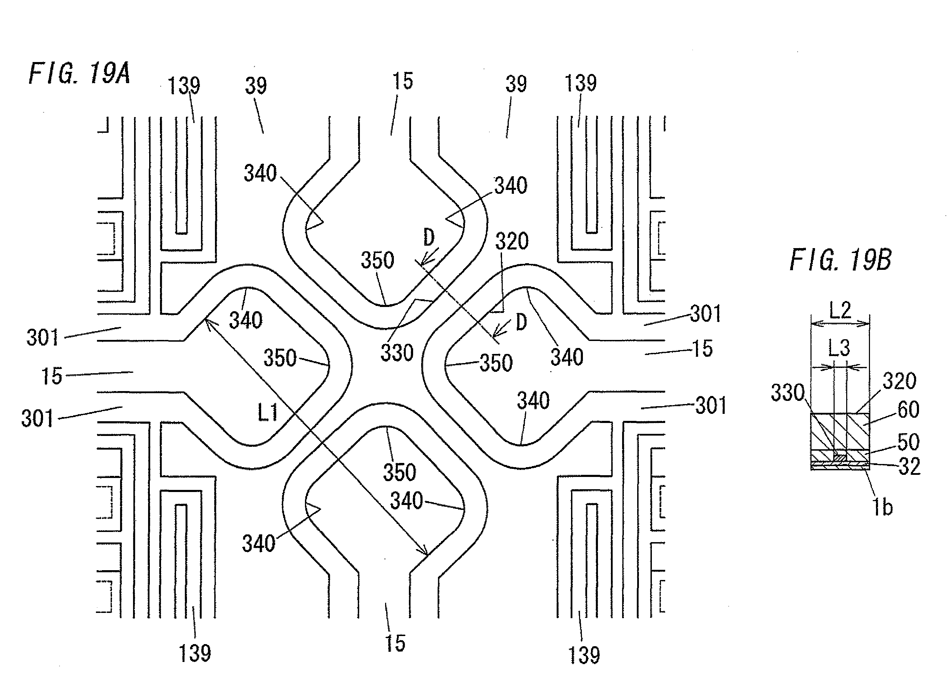

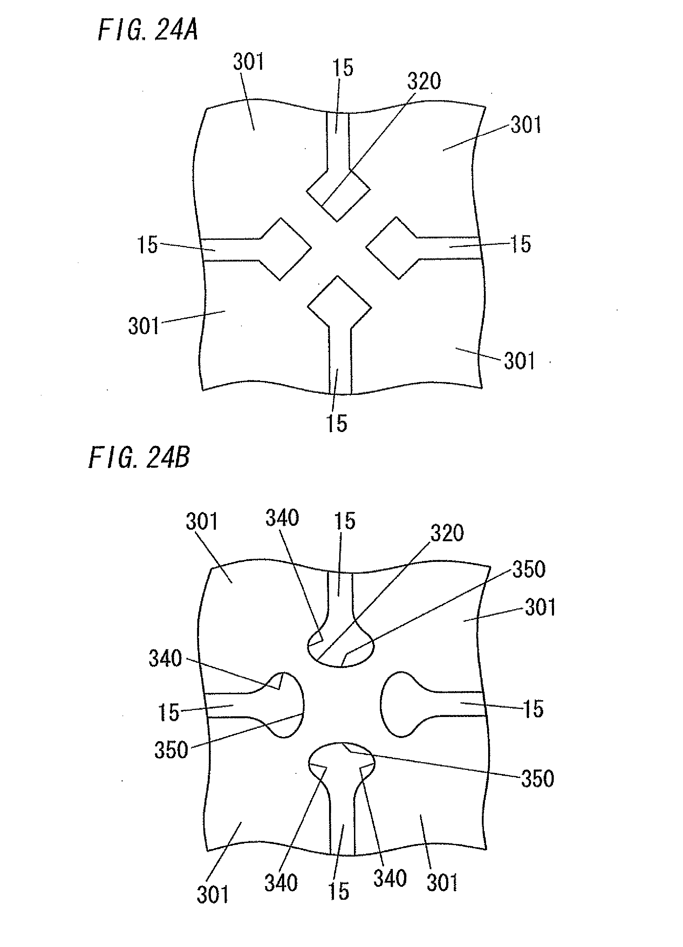

As shown in FIGS. 19 and 24B, the infrared sensor **1B** is chamfered at its corners between the connection member **320** and the small and thin film structure **301** to form thereat chamfered surfaces **340**. Further, corners between side surfaces of the cross-shaped connection members **320** which are approximately perpendicular to each other are chamfered to form chamfered surfaces **350**. This arrangement can reduce a stress which occurs at a junction portion of the connection member **320** and the small and thin film structure **301**, in contrast to a situation where the chamfered surfaces **340** and **350** are not formed as shown in FIG. 24B. Therefore, it is possible to reduce a residual stress which occurs at the time of manufacturing the infrared sensor **1B**, and to prevent breakage of the infrared sensor **1B** which would otherwise occur at the time of manufacturing the infrared sensor **1B**. Thus, fabrication yield can be improved. Additionally, it is possible to prevent breakage of the infrared sensor **1B** caused by a stress occurring due to an external temperature variation or impact at the time of using the infrared sensor **1B**. Besides, in the instance illustrated in FIG. 19, though each of the chamfered surfaces **340** and **350** is an R-surface having a curvature radius of 3 µm, each of the chamfered surfaces **340** and **350** may be a C-surface.

Moreover, the infrared sensor **1B** includes, for each small and thin film structure **301**, a malfunction diagnosis line **139** made of an n-type polysilicon layer. The malfunction diagnosis line **139** starts from and returns to the base **10** as being routed through one support member **310**, the infrared absorption member **33**, and the other support member **310**. All the malfunction diagnosis lines **139** are connected in series with each other. By energizing a series circuit of the m by n (3 by 2, in the illustrated instance) malfunction diagnosis lines **139**, it is possible to detect breakage such as breakage of the support member **310**.

The safeguard film **39**, the reinforcement member **330**, and the malfunction diagnosis line **139** contain the n-type impurity (e.g., phosphorus) of the same kind and the same impurity concentration (e.g., 10¹⁸ to 10²⁰ cm⁻³) as the n-type polysilicon layer **34**, and are formed at the same time as the n-type polysilicon layer **34**. For example, the p-type impurity of the p-type polysilicon layer **35** may be boron and the impurity concentration thereof may be in a range of about 10¹⁸ to 10²⁰ cm⁻³. In the present embodiment, each of the n-type polysilicon layer **34** and the p-type polysilicon layer **35** has an impurity concentration of 10¹⁸ to 10²⁰ cm⁻³. This arrangement can reduce a resistance of the thermocouple, and improve the S/N ratio. Besides, the safeguard film **39**, the reinforcement member **330**, and the malfunction diagnosis line **139** may be made of a p-type polysilicon layer. In this situation, the safeguard film **39**, the reinforcement member **330**, and the malfunction diagnosis line **139** may contain the impurity of the same kind and the same impurity concentration as the p-type polysilicon layer **35**.

In the present embodiment, each of the n-type polysilicon layer **34**, the p-type polysilicon layer **35**, the safeguard film **39**, the reinforcement member **330**, and the malfunction diagnosis line **139** has its thickness **t**₁ of **λ/4n₁**, wherein **n₂** denotes a reflective index of each of the n-type polysilicon layer **34**, the p-type polysilicon layer **35**, the safeguard film **39**, the reinforcement member **330**, and the malfunction diagnosis line **139**, and **λ** denotes a center wavelength of infrared to be detected by the infrared detection element **3.** This arrangement can enhance the absorption efficiency for infrared having a detection target wavelength (e.g., 8 to 12 µm), thereby improving the sensitivity. For example, when n₁ is 3.6 and λ is 10 µm, t₁ is about 0.69 µm.

Further, each of the n-type polysilicon layer **34**, the p-type polysilicon layer **35**, the safeguard film **39**, the reinforcement member **330**, and the malfunction diagnosis line **139** has an impurity concentration in a range of 10¹⁸ to 10²⁰ cm⁻³. Thus, an absorptance for infrared can be increased, and a reflection of the same infrared can be suppressed. Therefore, the S/N ratio of the output of the temperature detection member **30B** is improved. Further, the safeguard film **39**, the reinforcement member **330**, and the malfunction diagnosis line **139** can be formed through the same process as the n-type polysilicon layer **34**. Thus, it is possible to reduce the production cost.

In each pixel **2** of the infrared sensor **1B** of the present embodiment, a temperature detection member **30B** has its first end electrically connected to a source electrode **48** of a MOS transistor **4**, and its second end electrically connected to a reference bias line **5**. Further, a MOS transistor **4** has its drain electrode **47** electrically connected to a vertical read-out line **7** and its gate electrode **46** electrically connected to a horizontal signal line **6** which is made of an n-type polysilicon layer formed integrally with the same gate electrode **46**.

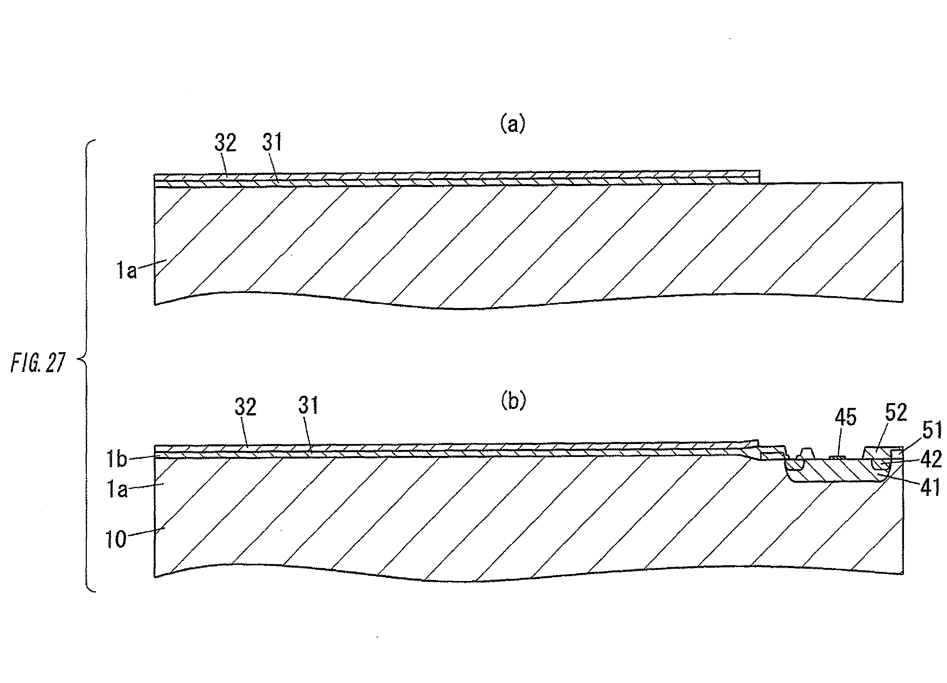

The following brief explanation is made to a method of manufacturing the infrared sensor **1B**, referring FIGS. 27 to 30.

First, the insulation layer forming step is performed, followed by the insulation layer patterning step. Thereby, a structure illustrated in (a) of FIG. 27 is obtained. The insulation layer forming step and the insulation layer patterning step have been already explained in the first embodiment, and no explanations thereof are deemed necessary.

The well region forming step is performed after the insulation layer patterning step, and thereafter the channel stopper region forming step is performed. Thereby, a structure illustrated in (b) of FIG. 27 is obtained. The insulation layer patterning step, the well region forming step and the channel stopper region forming step have been already explained in the first embodiment, and no explanations thereof are deemed necessary.

The gate insulation film forming step is performed after the channel stopper region forming step. The gate insulation film forming step has been already explained in the first embodiment, and no explanation thereof is deemed necessary.

After the gate insulation film forming step, the polysilicon layer forming step is performed. In the polysilicon layer forming step of the present embodiment, a non-doped polysilicon layer having a predetermined film thickness (e.g., 0.69 µm) is formed on the whole of the main surface of the silicon substrate 1a by use of an LPCVD technique. The non-doped polysilicon layer is used as a basis for forming the gate electrode **46**, the horizontal signal line **6** (see FIG. 13), the n-type polysilicon layer **34**, the p-type polysilicon layer **35**, and the safeguard film **39**, the reinforcement member **330**, and the malfunction diagnosis line **139**.

After the polysilicon layer forming step, the polysilicon layer patterning step is performed. In the polysilicon layer patterning step of the present embodiment, by use of the photolithography technique and the etching technique, the non-doped polysilicon layer is patterned in order to leave portions thereof respectively corresponding to the gate electrode **46**, the horizontal signal line **6**, the n-type polysilicon layer **34**, the p-type polysilicon layer **35**, the safeguard film **39**, the reinforcement member **330**, and the malfunction diagnosis line **139**.

The p-type polysilicon layer forming step is performed after the polysilicon layer patterning step. The p-type polysilicon layer forming step has been already explained in the first embodiment, and no explanation thereof is deemed necessary.

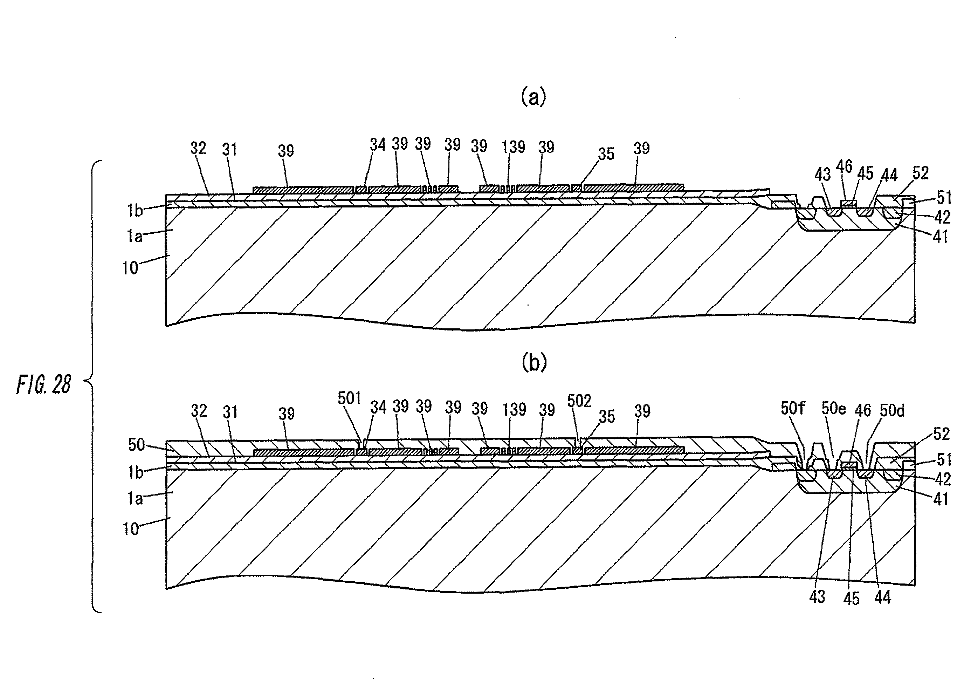

After the p-type polysilicon layer forming step, the n-type polysilicon layer forming step is performed. The n-type polysilicon layer forming step of the present embodiment is defined to perform an ion implantation of an n-type impurity (e.g., phosphorus) to portions of the non-doped polysilicon layer respectively corresponding to the n-type polysilicon layer **34**, the safeguard film **39**, the reinforcement member **330**, the malfunction diagnosis line **139**, the gate electrode **46**, and the horizontal signal line **6**, followed by the drive diffusion, thereby forming the n-type polysilicon layer **34**, the safeguard film **39**, the reinforcement member **330**, the malfunction diagnosis line **139**, the gate electrode **46**, and the horizontal signal line **6**. Thereby, a structure illustrated in (a) of FIG. 28 is obtained. Besides, the order of the p-type polysilicon layer forming step and the n-type polysilicon forming layer may be reversed.

After both the p-type polysilicon layer forming step and the n-type polysilicon layer forming step, the source/drain forming step, the interlayer dielectric film forming step, and the contact hole forming step are performed in this order. Thereby, a structure illustrated in (b) of FIG. 28 is obtained. The source/drain forming step, the interlayer dielectric film forming step, and the contact hole forming step have been already explained in the first embodiment, and no explanations thereof are deemed necessary.

After the contact hole forming step, the metal film forming step is performed. In the metal film forming step of the present embodiment, over the whole of the main surface of the silicon substrate **1a** is formed, by use of the sputtering, a metal film (e.g., Al-Si film) having a predetermined film thickness (e.g., 2 µm). The above metal film is a basis for forming the connection layers **36** and **37**, the drain electrode **47**, the source electrode **48**, the reference bias line **5**, the vertical read-out line **7**, the ground line **8**, the common ground line **9**, the pads **Vout, Vsel, Vref, Vdd,** and **Gnd** and the like (see FIG. 25).

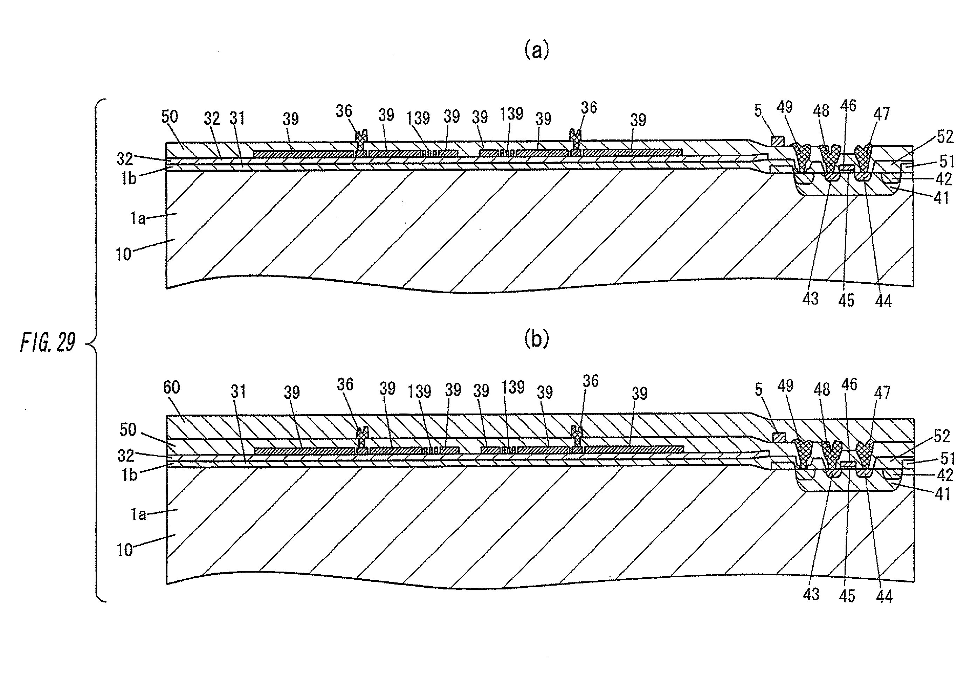

After the metal film forming step, the metal film patterning step is performed. In the metal film patterning step, by patterning the metal film by use of the photolithography technique and the etching technique, the connection layers **36** and **37**, the drain electrode **47**, the source electrode **48**, the reference bias line **5**, the vertical read-out line 7, the ground line **8**, the common ground line **9**, and the pads **Vout, Vsel, Vref, Vdd,** and **Gnd.** Thereby, a structure illustrated in (a) of FIG. 29 is obtained. Besides, in the metal film patterning step, the metal film is etched by use of RIE.

The passivation film forming step is performed after the metal film patterning step. Thereby, a structure illustrated in (b) of FIG. 29. The passivation film forming step has been already explained in the first embodiment, and no explanation thereof is deemed necessary.

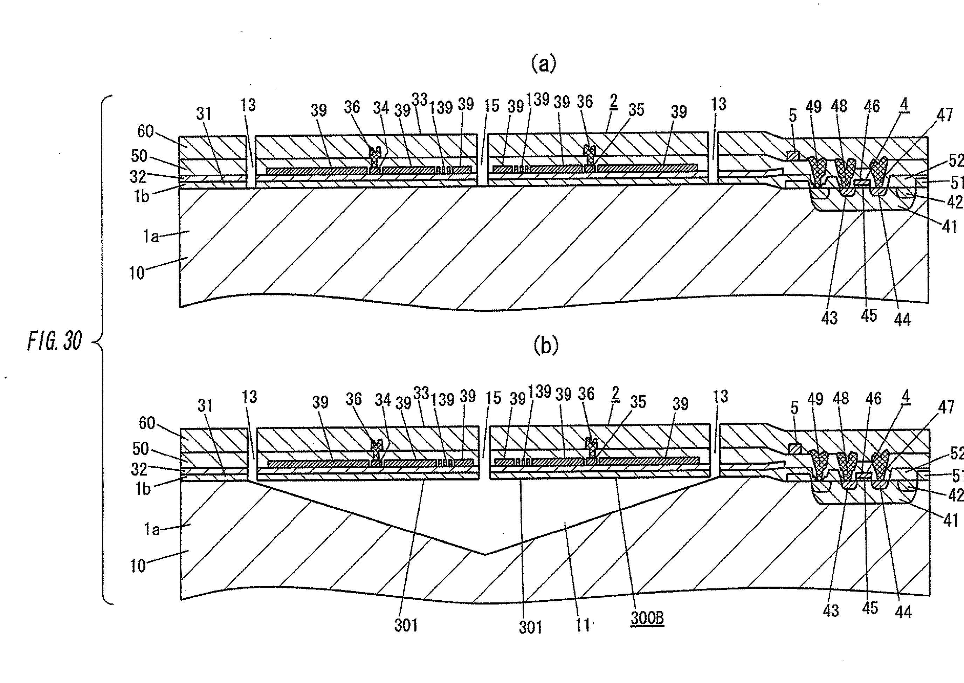

After the passivation film forming step, the laminate structure patterning step is performed. In the laminate structure patterning step, the thin film structure **300B** which includes the plural small and thin film structures **301** is formed by patterning a laminate structure which is composed of the thermal insulation layer defined as a laminate of the silicon dioxide film **31** and the silicon nitride film **32**, the temperature detection member **30B**, the interlayer dielectric film **50**, and the passivation film **60**. Thereby, a structure illustrated in (a) of FIG. 30 is obtained. Besides, in the laminate structure patterning step, the plural slits **13** and **15** are formed.

After the laminate structure patterning step, the opening forming step is performed, and thereafter the cavity forming step is performed. In the cavity forming step of the present embodiment, by making anisotropic etching of the silicon substrate **1a** with an etchant poured into each of the slits **13** and **15** as etchant conduits, the cavity **11** is formed in the silicon substrate 1a. Thereby, the infrared sensor **1B** in which the pixels 2 are arranged in a two dimensional array manner is obtained, as shown in (b) of FIG. 30. The opening forming step has been already explained in the first embodiment, and no explanation thereof is deemed necessary. In the cavity forming step, TMAH solution heated to a predetermined temperature (e.g., 85 °C) is used as the etchant. The etchant is not limited to the TMAH solution, but may be alkaline solution (e.g., KOH solution).

Besides, since all the steps from the insulation layer forming step to the cavity forming step are performed at wafer level, the separation step is made to separate the infrared sensors **1B** from each other after the cavity forming step.

In the infrared sensor **1B** of the present embodiment explained in the above, the thin film structure **300B** is divided into the plural small and thin film structures **301** by the plural linear slits **15**. The plural small and thin film structures **301** are aligned in the circumference direction of the cavity **11**. Each of the small and thin film structures **301** extends from the edge of the cavity **11** in the base **10** to the inside of the cavity **11**. Each of the small and thin film structures **301** is provided with a temperature detection member **30B**. All the temperature detection members **30B** are electrically connected to each other in such a relation as to provide the temperature-dependent output which is greater than any single one of the temperature detection members **30B**.

Therefore, the infrared sensor **1B** of the present embodiment can improve its response speed and sensitivity. Furthermore, since the connection member **320** connects together the small and thin film structures **301** which are adjacent to each other, it is possible to suppress occurrence of a warp of each small and thin film structure **301**. Thereby, it is possible to improve structural stability of the infrared sensor and to stabilize the sensitivity of the infrared sensor.

Furthermore, in the infrared sensor **1B** of the present embodiment, the safeguard film **39**, the reinforcement member **330**, and the malfunction diagnosis line **139** are formed on the infrared incident surface of the infrared absorption member **33**, in addition to the n-type polysilicon layer **34** and the p-type polysilicon layer **35**. Thus, it is possible to prevent the silicon nitride film **32** from being etched to be thinned at the time of forming the p-type polysilicon layer **35** and the n-type polysilicon layer **34**. In brief, in the polysilicon layer patterning step, it is possible to prevent thinning of the silicon nitride film **32** caused by over-etching which may occur at the time of etching the non-doped polysilicon layer used as a basis of both the n-type polysilicon layer **34** and the p-type polysilicon layer **35**. In addition, it is possible to improve uniform distribution of stress in the thin film structure **300B**. Consequently, it is possible to make the infrared absorption member **33** thin, yet the infrared absorption member **33** and the small and thin film structures **301** are kept free from a warp, and therefore it is possible to improve the sensitivity. Besides, in order to prevent the n-type polysilicon layer **34**, the p-type polysilicon layer **35**, the safeguard film **39**, the reinforcement member **330**, and the malfunction diagnosis line **139** from being etched by the etchant (e.g., TMAH solution) used in the cavity forming step, the n-type polysilicon layer **34**, the p-type polysilicon layer **35**, the safeguard film **39**, the reinforcement member **330**, and the malfunction diagnosis line **139** are shaped not to be exposed on inner aspects of the slits **13** and **15**.

Further, in the infrared sensor **1B**, the n-type polysilicon layer **34**, the p-type polysilicon layer **35**, and the safeguard film **39**, the reinforcement member **330**, and the malfunction diagnosis line **139** are configured to have the same thickness. Therefore, the uniform distribution of the stress in the small and thin film structure **301** can be improved. Thus, it is possible to keep the small and thin film structure **301** free from a warp.

In addition, since the infrared sensor **1B** includes the MOS transistor **4** for each pixel **2**, it is possible to reduce the number of the output pads **Vout**, and therefore it is possible to downsize the infrared sensor **1B** and reduce the production cost thereof. Besides, each pixel **2** need not be provided with a MOS transistor **4**.

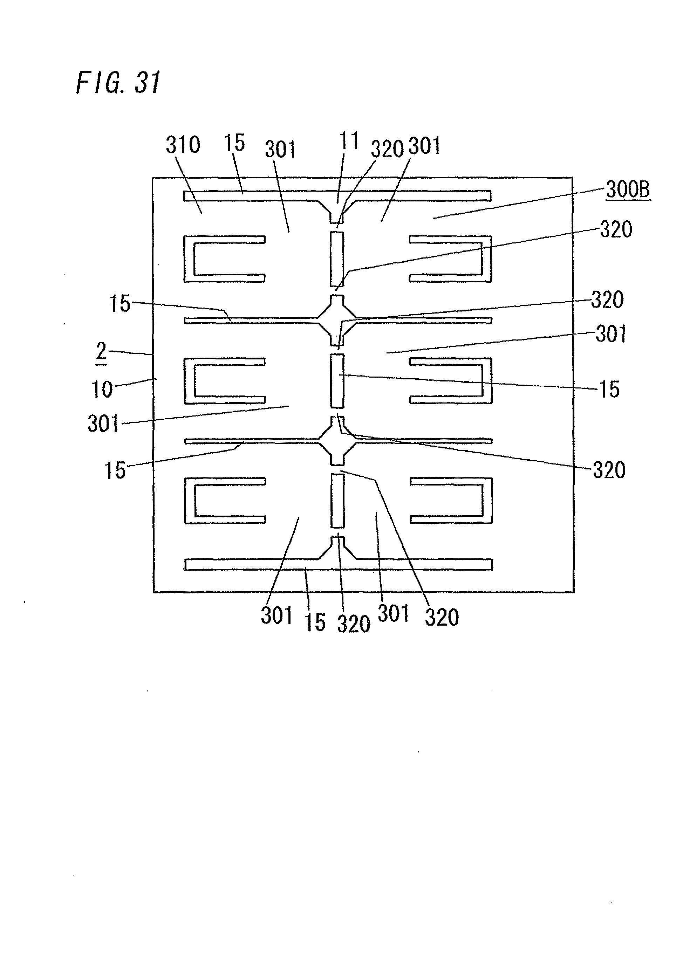

FIG. 31 shows the first modification of the infrared sensor **1B** of the present embodiment. The first modification is different in the thin film structure **300B** from the basic example of the infrared sensor **1B** of the present embodiment shown in FIGS. 13 to 30.

According to the thin film structure **300B** of the first modification of the infrared sensor **1B**, the small and thin film structures **301** are disposed adjacent to each other in an extension direction thereof (a lengthwise direction of the small and thin film structure, i.e., a lateral direction in FIG. 31), and are coupled by means of two connection members **320** which are spaced from each other in a direction crossing with the extension direction (i.e., a width direction of the small and thin film structure **301**).

According to the first modification, each of the small and thin film structures **301** and **301** has its first end (first end in the extension direction) directly connected to one edge of the cavity **11** in the base **10,** and has its second end (second end in the extension direction) connected to another edge of the cavity **11** in the base by use of the connection member **320** and another small and thin film structure **301**. As described in the above, each of the small and thin film structures **301** is supported to the base **10** at its opposite ends. Therefore, a possible warp of the small and thin film structure **301** can be reduced, and therefore the sensitivity can be stabilized, and the fabrication yield can be improved. Besides, the small and thin film structures **301** and **341**, which are juxtaposed to each other in the extension direction, may be coupled to each other at the width centers thereof by means of a single connection member **320**.

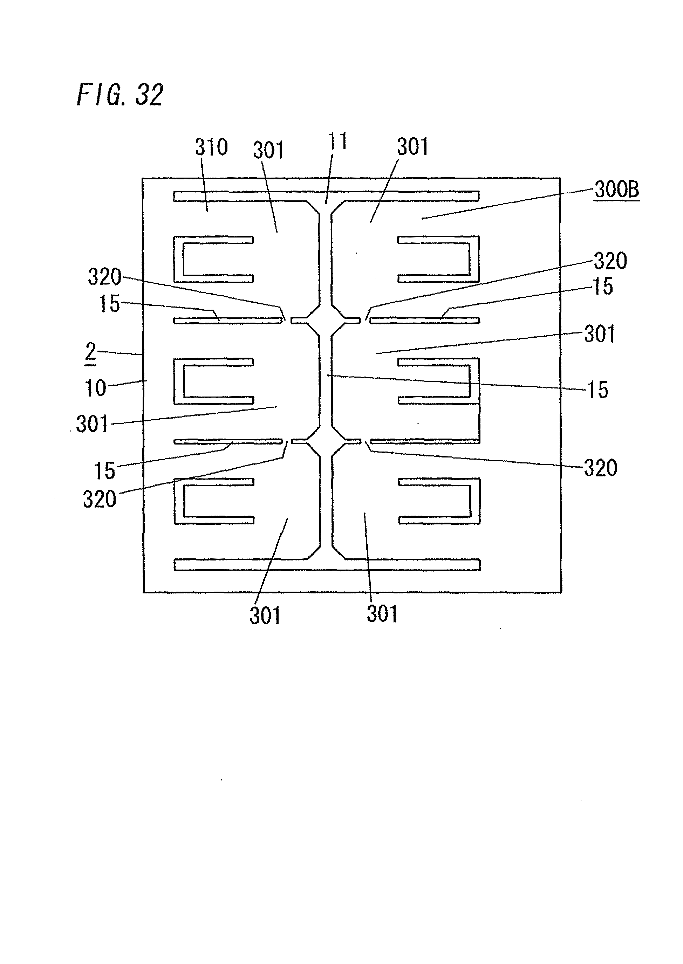

FIG. 32 shows the second modification of the infrared sensor **1B** of the present embodiment. The second modification is different in the thin film structure **300B** from the basic example.

According to the infrared sensor **1B** of the second modification, the small and thin film structures **301** and **301**, which are juxtaposed to each other in a direction (width direction of the small and thin film structure **301**, that is, upward/downward direction in FIG. 32) perpendicular to the extension direction of the small and thin film structures, are coupled to each other by means of the single connection member **320** at the portions other than the support members **310**. Besides, the connection member **320** is preferred to be located away from the support member **310**.

According to the second modification, each of the small and thin film structure 301 has an improved torsional stiffness, and therefore it is possible to prevent torsional deformation of each small and thin film structure **301**. Thus, the sensitivity can be stabilized, and the fabrication yield can be improved.

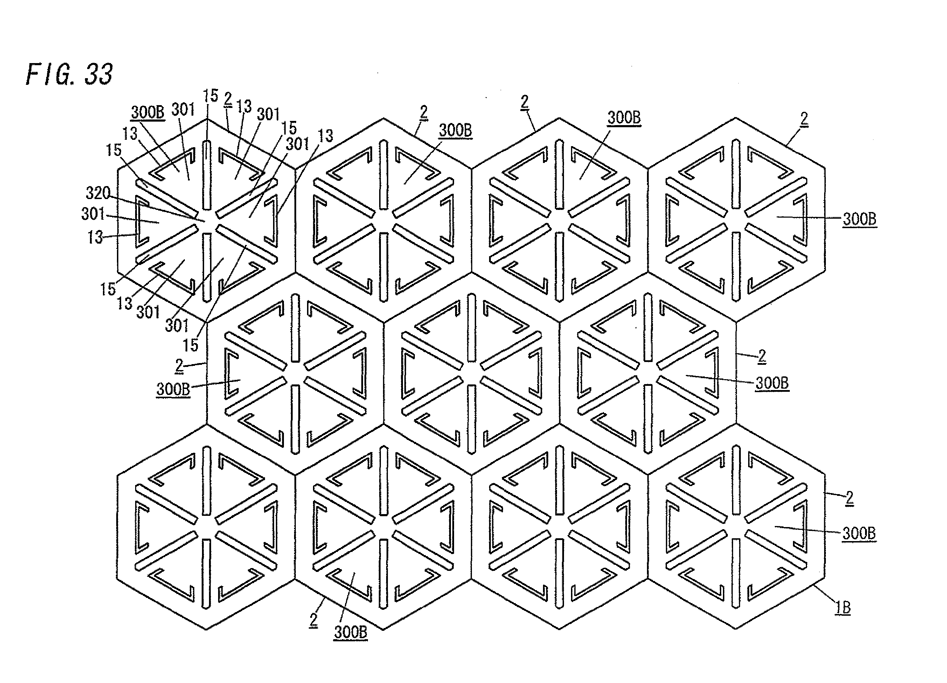

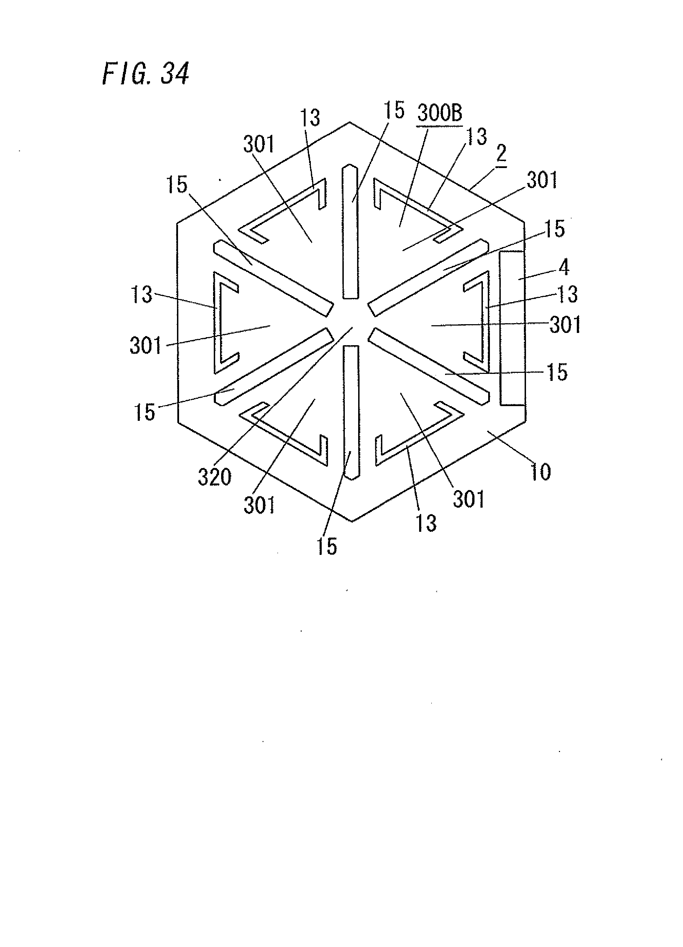

FIGS. 33 and 34 show the third modification of the infrared sensor **1B** of the present embodiment. The third modification is different in the pixel 2 from the basic example.

In the third modification of the infrared sensor **1B**, each pixel **2** is formed into a hexagonal shape. The plural pixels **2** are arranged in a honeycomb manner.

The thin film structure **300B** of the third modification is divided into the plural (six, in the illustrated instance) small and thin film structures **301** by the plural (six, in the illustrated instance) slits **15**. The plural small and thin film structures **301** are connected to each other by the connection member **320**.

The aforementioned third modification can prevent deformation of each small and thin film structure **301**. Additionally, it is possible to improve density of the small and thin film structures **301** as well as density of the pixels **2**.

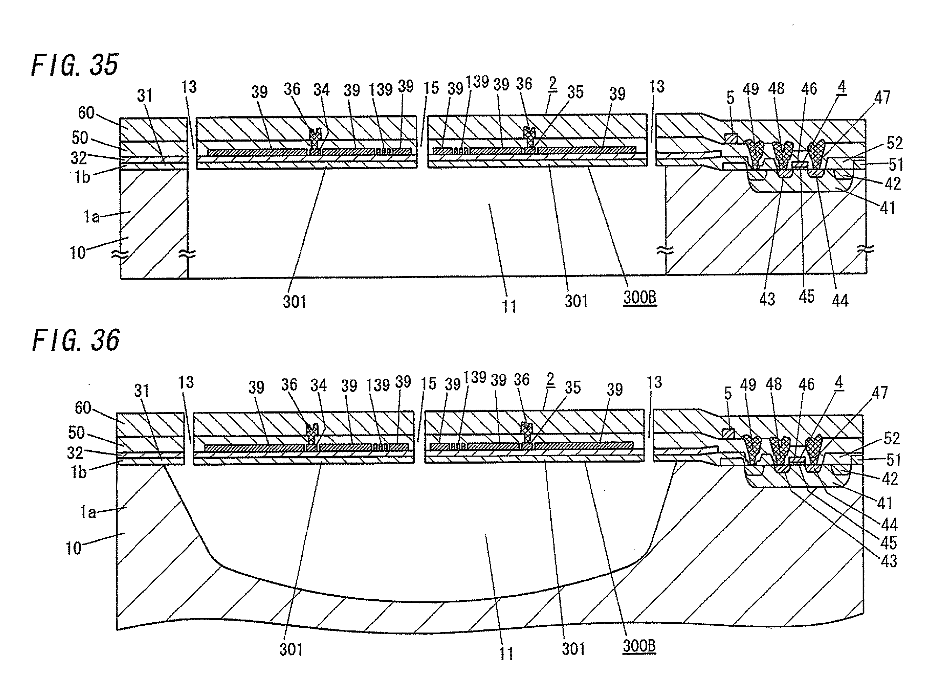

FIG. 35 shows the fourth modification of the infrared sensor **1B** of the present embodiment. The fourth modification is different from the basic example in that the cavity **11** of the base **10** is formed from a second surface (lower surface, in FIG. 35) of the base **10**.

In order to manufacture the infrared sensor **1B** of the fourth modification, the cavity forming step is modified as follows. In the cavity forming step, a region reserved for forming the cavity **11** in the second surface of the base **10** (i.e., a lower surface of the silicon substrate **1a**, in FIG. 35) is etched by means of anisotropic etching with a dry etching apparatus of an induction coupled plasma (ICP) type or the like to form the cavity **11**.

The fourth modification can suppress heat transfer from each of the small and thin film structures **310** of the thin film structure **300B** to the base **10**, thereby more improving the sensitivity.

FIG. 36 shows the fifth modification of the infrared sensor **1B** of the present embodiment. The fifth modification is different from the basic example in that the cavity **11** of the base **10** has its inner surface shaped into a recessed surface.

The cavity 11 of the fifth embodiment is formed by means of isotropic etching, for example.

According to the fifth modification, the inner surface of the cavity **11** can reflect infrared passing through the thin film structure **300B** toward the thin film structure **300**. Thus, it is possible to increase an amount of infrared absorption of the infrared absorption member **33**, and therefore the sensitivity can be improved.

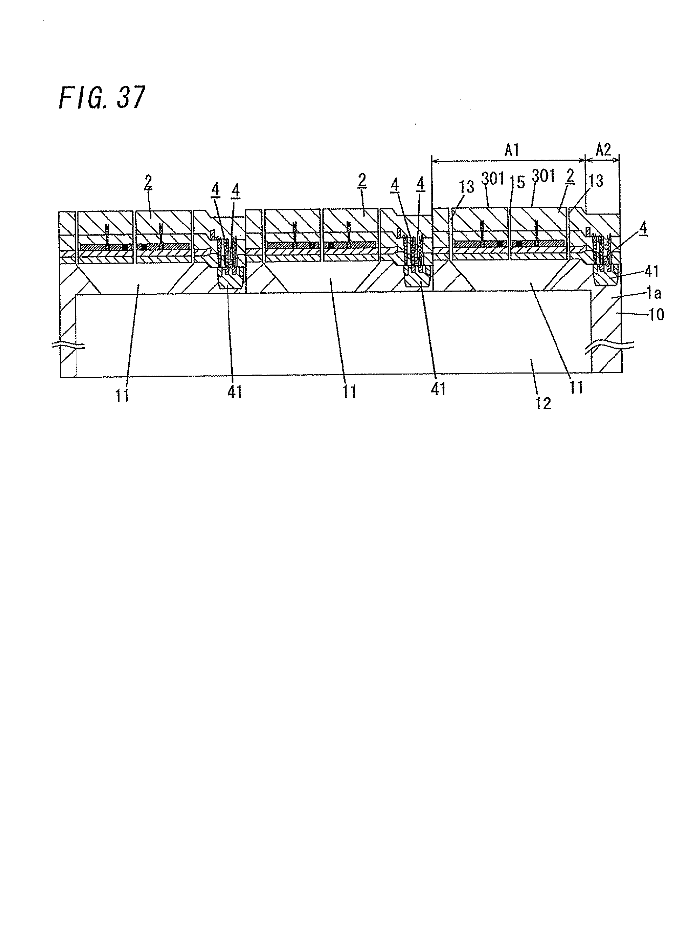

FIG. 37 shows the sixth modification of the infrared sensor **1B** of the present embodiment. The sixth modification is different from the basic example in that the base **10** is provided its second surface with an opening **12** configured to communicate the plural cavities **11**.

The opening **12** may be formed by etching a region reserved for forming the opening **12** of the second surface of the base **10** (i.e., a lower surface of the silicon substrate **1a**, in FIG. 37) by means of anisotropic etching with a dry etching apparatus of an ICP type or the like.

The sixth modification can more suppress heat transfer from each of the small and thin film structures **310** of the thin film structure **300B** to the base **10**, thereby more improving the sensitivity.

### (FOURTH EMBODIMENT)

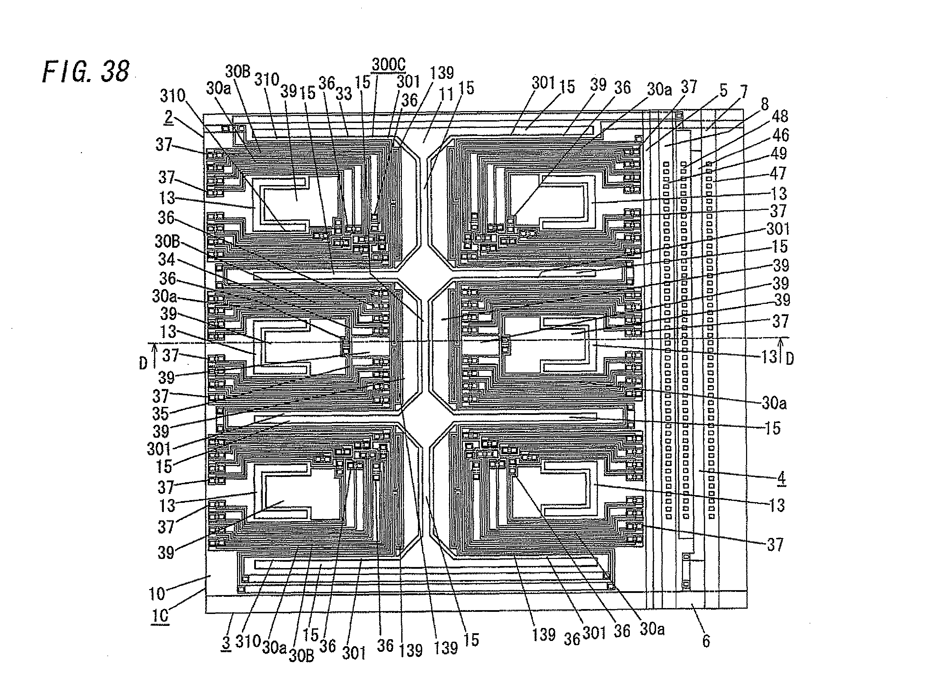

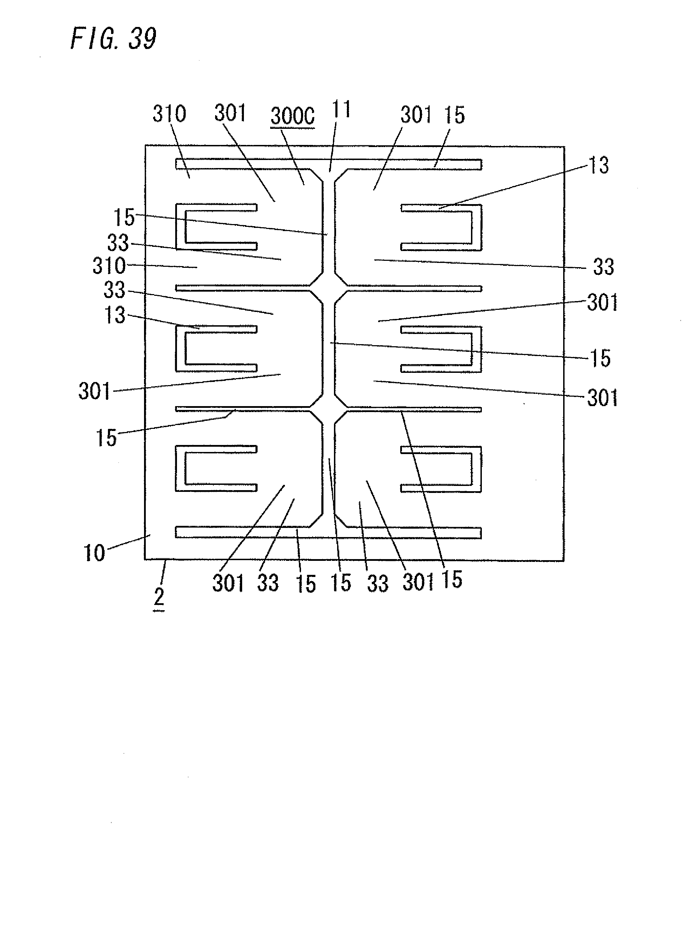

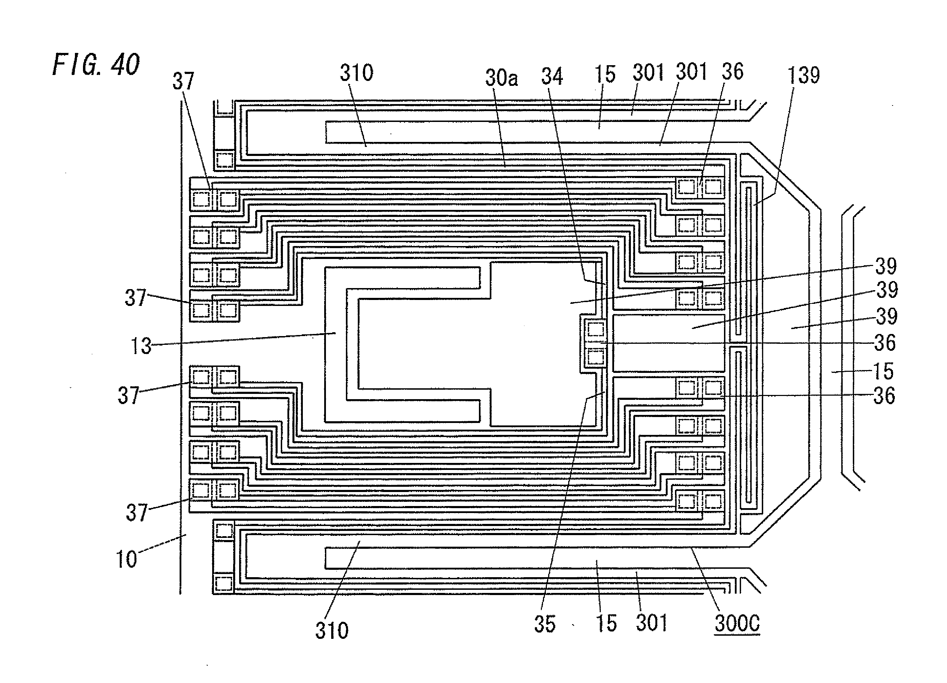

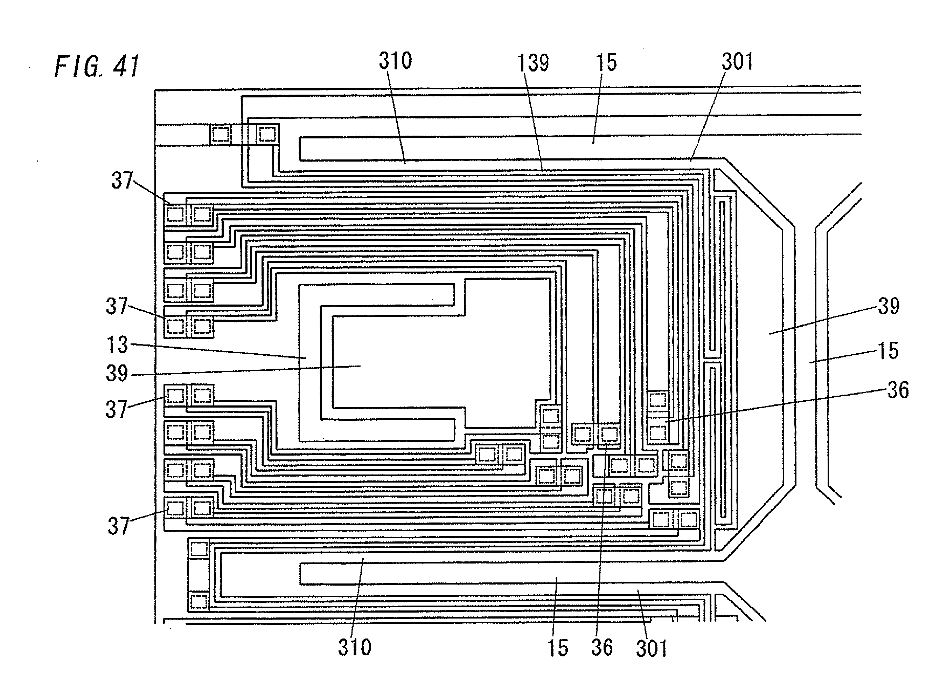

The following explains the infrared sensor **1C** of the present embodiment with reference to FIGS. 38 to 44.

The infrared sensor 1C of the present embodiment is different from the infrared sensor **1B** of the third embodiment mainly in the thin film structure **300C**. Besides, components common to the infrared sensor **1B** and the infrared sensor 1 are designated by the same reference numerals and no explanation thereof are deemed necessary.

The thin film structure **300C** of the present embodiment is different from the thin film structure **300B** in that the thin film structure **300C** is devoid of the connection member 320. In brief, according to the thin film structure **300C**, each of the small and thin film structures **301** is supported to the base **10** in a cantilever fashion.

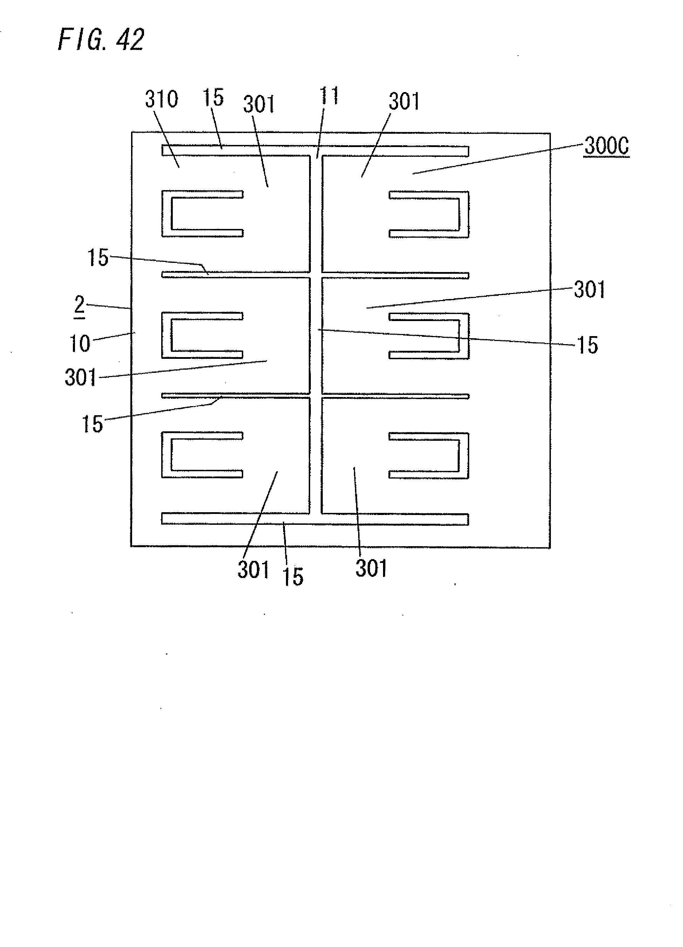

The infrared sensor **1C** is chamfered at its corners formed between a tip of the small and thin film structure **301** in the extension direction and each of width ends of the same. Thus, it is enabled to prevent breakage of the infrared sensor **1C** at the time of manufacturing the same which might otherwise occur when the infrared sensor is not so chamfered, as shown in FIG. 42. Thus, the cavity **11** can be also formed easily. Thus, the fabrication yield can be improved. Besides, in the illustrated instance, though each of the chamfered surfaces is a C-surface, each of the chamfered surfaces may be an R-surface.

A method for manufacturing the infrared sensor **1C** is the same as the method for manufacturing the infrared sensor **1B** of the third embodiment, except the connection member **320** and the reinforcement member **330** are not formed. Therefore, no explanation is made to the method for manufacturing the infrared sensor **1C**.

In the infrared sensor **1C** of the present embodiment explained in the above, the thin film structure **300C** is divided into the plural small and thin film structures **301** by the plural linear slits **15.** The plural small and thin film structures **301** are aligned in the circumference direction of the cavity **11**. Each of the small and thin film structures **301** is supported to the base **10** in a cantilever fashion. Further, each small and thin film structure **301** is provided with a temperature detection member **30B**. All the temperature detection members **30B** are electrically connected to each other in such a relation as to provide the temperature-dependent output which is greater than any single one of the temperature detection members **30B**.

Therefore, the infrared sensor **1C** of the present embodiment can improve its response speed and sensitivity. Furthermore, it is possible to restrain deformation of each small and thin film structure **301** even in the presence of a stress in the base **10** or subject to external stress or thermal stress. Thereby, it is possible to improve structural stability of the infrared sensor and to stabilize the sensitivity of the infrared sensor.

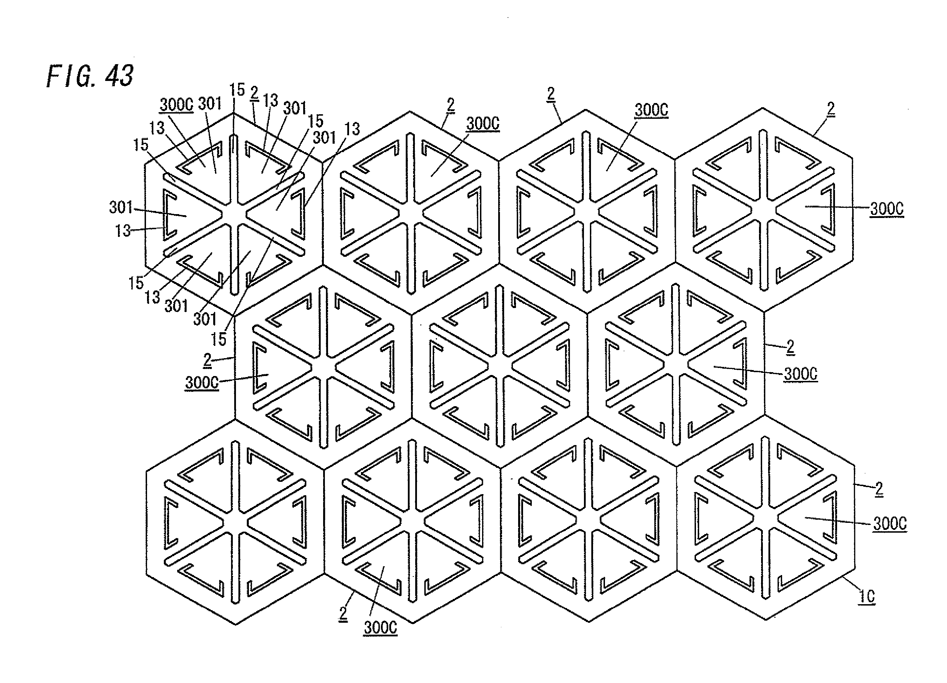

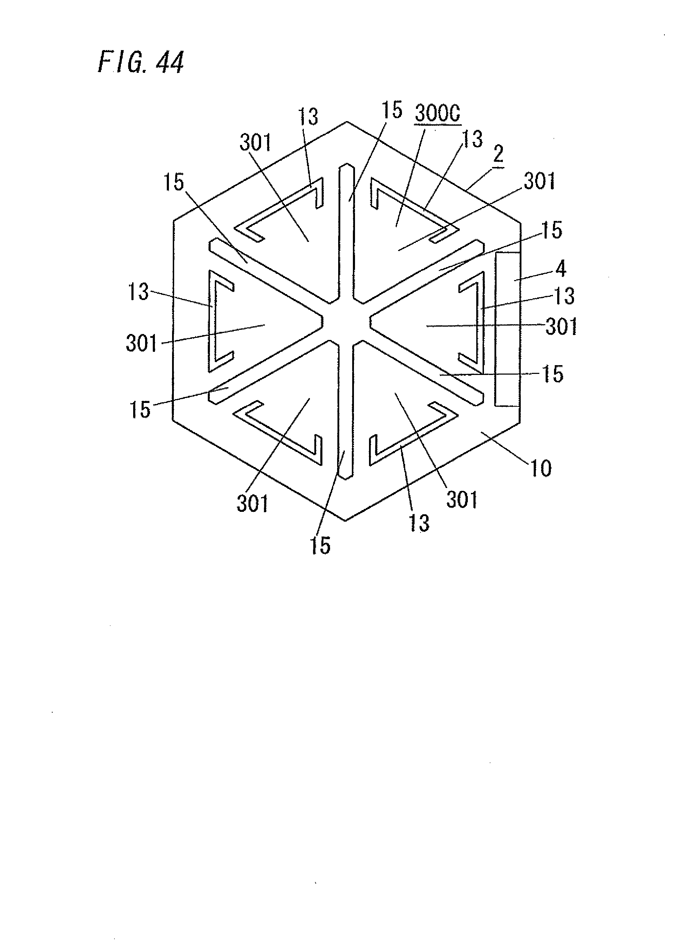

Alternatively, as shown in FIGS. **43** and **44**, each pixel **2** may be formed into a hexagonal shape. In this situation, the pixels **2** are preferred to be arranged in a honeycomb manner.

With this arrangement, it is possible to prevent deformation of each small and thin film structure **301**. Additionally, it is possible to improve density of the small and thin film structures 301 as well as density of the pixels 2.

## Claims

1. An infrared sensor comprising:
a base; and
an infrared detection element formed over a surface of said base,
wherein
said infrared detection element comprises:
an infrared absorption member in the form of a thin film configured to absorb infrared, and spaced from the surface of said base for thermal insulation;
a temperature detection member configured to measure a temperature difference between said infrared absorption member and said base, and including a thermocouple, said thermocouple including a p-type polysilicon layer, an n-type polysilicon layer, and a connection layer, said p-type polysilicon layer formed over said infrared absorption member and said base, said n-type polysilicon layer formed over said infrared absorption member and said base without contact with said p-type polysilicon layer, and said connection layer being configured to electrically connect said p-type polysilicon layer to said n-type polysilicon layer; and
a safeguard film configured to serve to protect said infrared absorption member and prevent a warp of said infrared absorption member at the time of forming said p-type polysilicon layer and said n-type polysilicon layer,
said safeguard film being a polysilicon layer formed on an infrared incident surface defined as an opposite surface of said infrared absorption member from said base to cover said infrared incident surface.

2. The infrared sensor as set forth in claim 1, wherein
said infrared detection element includes a support member configured to couple said infrared absorption member to said base,
said support member being coupled to said base only at a single point.

3. The infrared sensor as set forth in claim 1, wherein
said infrared detection element includes a support member configured to couple said infrared absorption member to said base,
said support member being coupled to said infrared absorption member only at two points.

4. The infrared sensor as set forth in claim 1, wherein
said p-type polysilicon layer, said n-type polysilicon layer, and said safeguard film have the same thickness.

5. The infrared sensor as set forth in claim 1, wherein
said p-type polysilicon layer, said n-type polysilicon layer, and said safeguard film are formed in a common plane.

6. The infrared sensor as set forth in claim 1, wherein
said infrared detection member includes an infrared absorption film formed over an opposite surface of said safeguard film from said base,
said infrared absorption film having its thickness of λ/4n, wherein n denotes a reflective index of said infrared absorption film, and λ denotes a center wavelength of the infrared to be detected by said infrared detection element.

7. The infrared sensor as set forth in claim 1, wherein
said safeguard film comprises a p-type safeguard film formed integrally with said p-type polysilicon layer and having an impurity concentration of 10¹⁸ to 10²⁰ cm⁻³, and an n-type safeguard film formed integrally with said n-type polysilicon layer and having an impurity concentration of 10¹⁸ to 10²⁰ cm⁻³.

8. The infrared sensor as set forth in claim 1, wherein
said safeguard film has an impurity concentration of 10¹⁸ to 10²⁰ cm⁻³,
said safeguard film having its thickness of λ/4n, wherein n denotes a reflective index of said safeguard film, and λ denotes a center wavelength of the infrared to be detected by said infrared detection element.

9. The infrared sensor as set forth in claim 1, wherein
said safeguard film has an impurity concentration of 10¹⁸ to 10²⁰ cm⁻³,
at least one of said p-type polysilicon layer and said n-type polysilicon layer having the impurity of the same kind and the same concentration as said safeguard film.

10. The infrared sensor as set forth in claim 1, wherein
said infrared sensor includes plural cells each including said infrared detection element,
said plural cells being arranged over the surface of said base in an array manner.

11. The infrared sensor as set forth in claim 10, wherein
said cell includes a MOS transistor configured to read out an output of said temperature detection member.

12. The infrared sensor as set forth in claim 11, wherein
said MOS transistor includes a gate electrode defined by a polysilicon film having the same thickness as said safeguard film.

13. The infrared sensor as set forth in claim 1, wherein
said base is provided with a cavity for thermally insulation between said base and said infrared absorption member,
said infrared detection member including a thin film structure which comprises a plurality of a small and thin film structures, and is disposed over said cavity,
each of said small and thin film structures including said infrared absorption member in the form of a thin film configured to absorb infrared, and said temperature detection member formed on said infrared absorption member and configured to measure a temperature of the same infrared absorption member,
said infrared detection member including slits formed between said small and thin film structures, and
all said temperature detection members being electrically connected to each other in such a relation as to provide a temperature-dependent output which is greater than any single one of said temperature detection members.

14. The infrared sensor as set forth in claim 13, wherein
said thin film structure includes a connection member configured to connect said small and thin film structures together.
